# EUROPEAN PATENT APPLICATION

(11) **EP 4 793 948 A1**
(43) Date of publication of application: **19.08.2026**
(21) Application number: 26158611.9
(22) Date of filing: 13.02.2026
(51) Int. Cl.: G11C 5/02, G11C 16/24, G11C 16/26, G11C 16/04

(54) **MEMORY DEVICE INCLUDING PAGE BUFFER**

(30) Priority: 17.02.2025 KR 20250020378; 20.11.2025 KR 20250177150
(71) Applicant: Samsung Electronics Co., Ltd., Suwon-si, Gyeonggi-do 16677 (KR)
(72) Inventor: CHOI, Seungyong, 16677 Suwon-si (KR); LIM, Bongsoon, 16677 Suwon-si (KR); BAEK, Seheon, 16677 Suwon-si (KR); PARK, Sangwon, 16677 Suwon-si (KR)
(74) Representative: Marks & Clerk LLP

(57) **Abstract**

A memory device includes a first semiconductor layer including a first cell region and a second cell region over the first cell region, and a second semiconductor layer under the first semiconductor layer in a substantially vertical direction and including a page buffer circuit which includes a first page buffer set associated with odd data and a second page buffer set associated with even data, the first cell region includes first memory cells, a first odd bit line transmitting odd data of the first memory cells, and a first even bit line transmitting even data of the first memory cells, the second cell region includes second memory cells, a second odd bit line transmitting odd data of the second memory cells, and a second even bit line transmitting even data of the second memory cells.

## Description

### FIELD

The disclosure relates to a memory device, and more particularly, to a memory device including a page buffer.

### BACKGROUND

With the increasing multi-functionality of information and communication devices, there is a growing demand for larger memory capacities and higher integration. As memory cell sizes are reduced for higher integration, operational circuits and/or wiring structures included in memory devices for operation and electrical connection are also more complex. Accordingly, there is a growing demand for memory devices with increased integration and also improved electrical characteristics. To improve storage capacities and integration of memory devices, research is being conducted on non-volatile memory devices, in which memory cells are stacked in a three-dimensional structure, such as three-dimensional (3D) NAND flash memory.

For NAND flash memory, 4 KB read and 8 KB read may be used in some situations, such as 16 KB sequential read and random read, depending on applications. Word lines of NAND flash memory are structured in units of 8K, but to reduce an area and improve input/output (I/O) performance, data is stored separately on the left 8K word lines and the right 8K word lines. Due to this, a problem has arisen in that the power consumed for 16 KB read is equal to the power consumed for 8 KB read.

### SUMMARY

According to aspects of the disclosure, there is provided a memory device including a first semiconductor layer including a first cell region and a second cell region over the first cell region, and a second semiconductor layer arranged under the first semiconductor layer in a substantially vertical direction and including a page buffer circuit which includes a first page buffer set associated with odd data and a second page buffer set associated with even data, the first cell region includes a plurality of first memory cells, a first odd bit line transmitting odd data of the plurality of first memory cells, and a first even bit line transmitting even data of the plurality of first memory cells, the second cell region includes a plurality of second memory cells, a second odd bit line transmitting odd data of the plurality of second memory cells, and a second even bit line transmitting even data of the plurality of second memory cells, the first page buffer set is connected to the first odd bit line of the first cell region and the second odd bit line of the second cell region, and the second page buffer set is connected to the first even bit line of the first cell region and the second even bit line of the second cell region.

According to aspects of the disclosure, there is provided a memory device including a first semiconductor layer including a first sub-block which includes a plurality of first memory cells, a first even bit line corresponding to even data of the plurality of first memory cells, and a first odd bit line corresponding to odd data of the plurality of first memory cells, and a second sub-block which includes a plurality of second memory cells, a second even bit line corresponding to even data of the plurality of second memory cells, and a second odd bit line corresponding to odd data of the plurality of second memory cells, and a second semiconductor layer arranged under the first semiconductor layer in a substantially vertical direction and including a page buffer circuit which includes a first page buffer set associated with odd data and a second page buffer set associated with even data, wherein the first page buffer set is connected to the first odd bit line of the first cell region and the second odd bit line of the second cell region, and the second page buffer set is connected to the first even bit line of the first cell region and the second even bit line of the second cell region.

According to aspects of the disclosure, there is provided a memory device including a first semiconductor layer including a first sub-block which includes a plurality of first memory cells and first even bit lines corresponding to the plurality of first memory cells, a second sub-block which includes a plurality of second memory cells and first odd bit lines corresponding to the plurality of second memory cells, a third sub-block which includes a plurality of third memory cells and second even bit lines corresponding to the plurality of third memory cells, and a fourth sub-block which includes a plurality of fourth memory cells and second odd bit lines corresponding to the plurality of fourth memory cells; and a second semiconductor layer arranged under the first semiconductor layer in a substantially vertical direction and including a page buffer circuit which includes a first page buffer set associated with odd data and a second page buffer set associated with even data, wherein the first page buffer set is connected to the first odd bit line of the second sub-block and the second odd bit line of the fourth sub-block, and the second page buffer set is connected to the first even bit line of the first sub-block and the second even bit line of the third sub-block.

At least some of the above and other features of the invention are set out in the claims.

### BRIEF DESCRIPTION OF THE DRAWINGS

Embodiments will be more clearly understood from the following detailed description taken in conjunction with the accompanying drawings in which:
FIG. 1 is a diagram illustrating a memory device according to embodiments;
FIG. 2 is a diagram illustrating a memory device according to embodiments;
FIG. 3A is a diagram illustrating a memory block according to embodiments;
FIG. 3B is a diagram illustrating a memory block according to embodiments;
FIG. 3C is a diagram illustrating another example of a memory block according to embodiments;
FIG. 4A illustrates a connection between a page buffer and bit lines, according to a comparative example;
FIG. 4B illustrates a connection between a page buffer and bit lines, according to a comparative example;
FIG. 5A illustrates a connection between a page buffer and bit lines, according to embodiments;
FIG. 5B illustrates a connection between a page buffer and bit lines, according to embodiments;
FIG. 6A illustrates a connection between a page buffer and bit lines, according to embodiments;
FIG. 6B illustrates a connection between a page buffer and bit lines, according to embodiments;
FIG. 7A illustrates another example of a connection between a page buffer and bit lines, according to embodiments;
FIG. 7B illustrates another example of a connection between a page buffer and bit lines, according to embodiments;
FIG. 8A illustrates another example of a connection between a page buffer and bit lines, according to embodiments;
FIG. 8B illustrates another example of a connection between a page buffer and bit lines, according to embodiments;
FIG. 8C illustrates an example of a connection between a page buffer and bit lines, according to a comparative example;
FIG. 8D illustrates an example of a connection between a page buffer and bit lines, according to a comparative example;
FIG. 9A illustrates an example of a connection between bit lines, according to embodiments;
FIG. 9B illustrates an example of a connection between bit lines, according to embodiments;
FIGS. 10A to 10C illustrate other examples of a connection between a page buffer and bit lines according to embodiments;
FIG. 11 is a cross-sectional view of a memory device having a B-VNAND structure, according to embodiments;
FIG. 12 is a block diagram illustrating an example in which a memory device according to embodiments is applied to a solid state disk (SSD) system; and
FIG. 13 is a block diagram of a system illustrating an electronic device including a memory device, according to embodiments.

### DETAILED DESCRIPTION

Hereinafter, embodiments are described in detail with reference to the attached drawings.

The disclosure provides a memory device that includes a page buffer asymmetrically connected to bit lines.

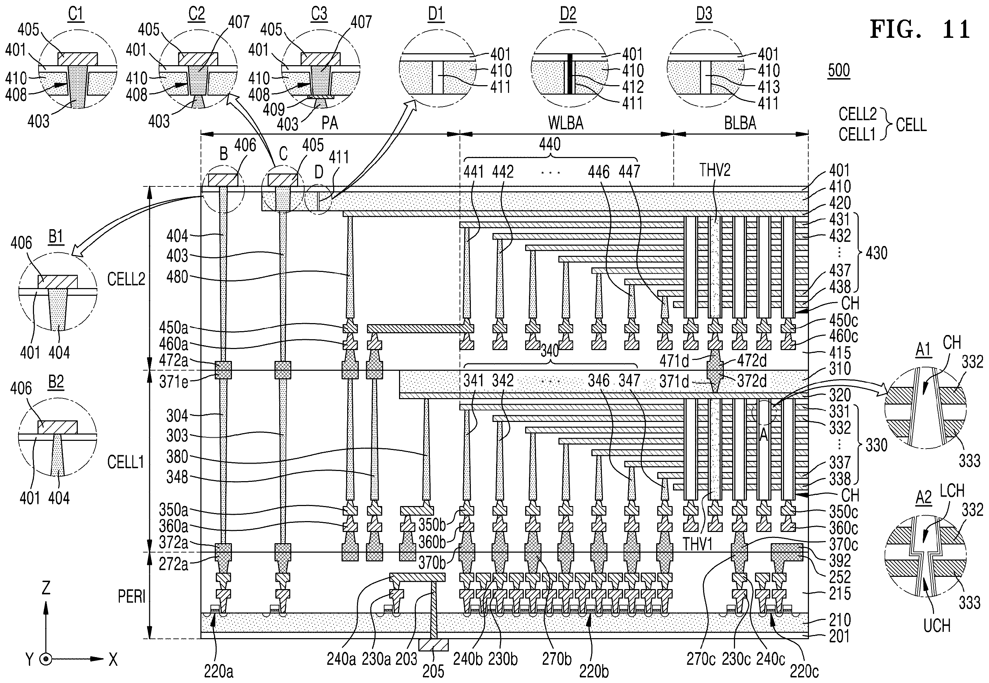

According to one or more embodiments, a memory device described in the disclosure includes memory blocks having a three-dimensional structure, each of which may include NAND flash memory cells. The memory device may have a chip-to-chip (C2C) structure. The C2C structure is obtained by manufacturing at least one upper chip including a cell region and a lower chip including a peripheral circuit region PERI, and then connecting the at least one upper chip to the lower chip through bonding. The C2C structure may include two upper chips. However, this is merely an example, and the number of upper chips is not limited thereto. When a memory device includes two upper chips, a first upper chip including a first cell region CELL1, a second upper chip including a second cell region CELL2, and a lower chip including a peripheral circuit region PERI may be connected to each other by a bonding method as illustrated in FIG. 11. Hereinafter, a memory device may include a plurality of memory blocks, a single memory block may include multiple sub-blocks, and the multiple sub-blocks may be connected to word lines or connected to word lines and bit lines. For the sake of convenience of description, a memory device may be referred to interchangeably as a non-volatile memory device.

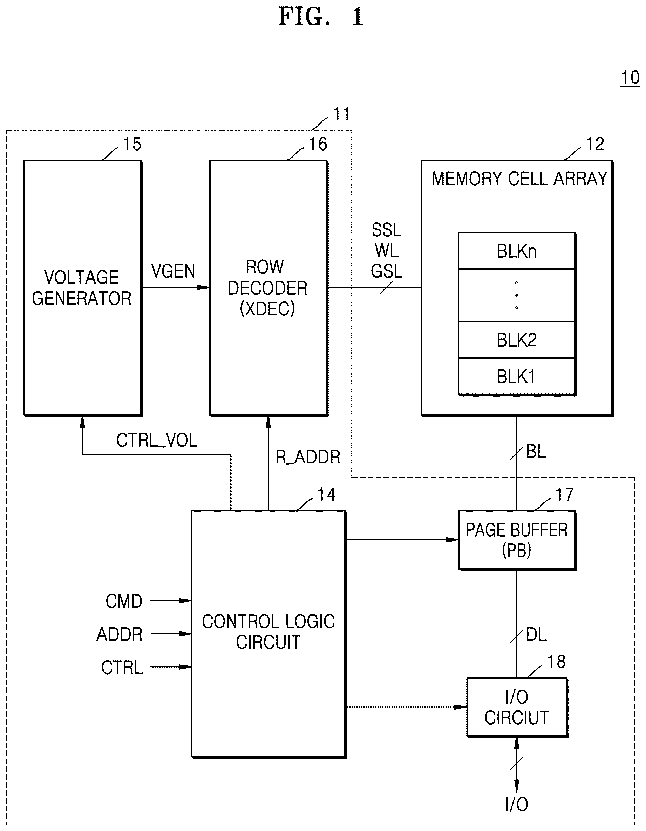

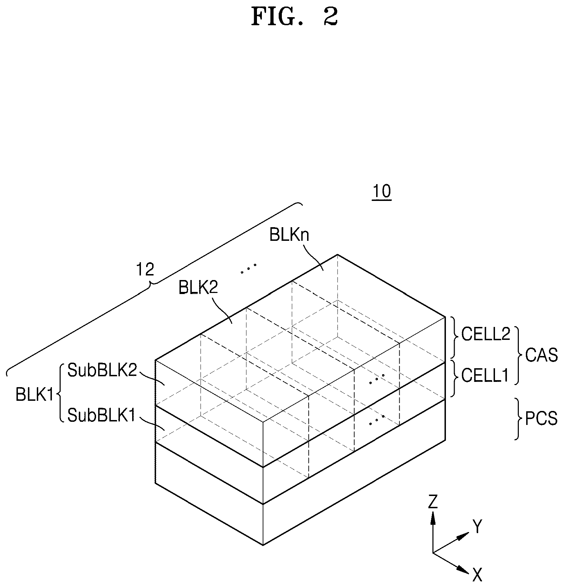

FIGS. 1 and 2 are diagrams illustrating memory devices according to embodiments. FIG. 1 is a block diagram conceptually illustrating a memory device 10 according to the disclosure, and FIG. 2 is a diagram schematically illustrating a structure of the memory device 10 of FIG. 1.

Referring to FIG. 1, the memory device 10 includes a peripheral circuit 11 and a memory cell array 12, and the peripheral circuit 11 may include a control logic circuit 14, a voltage generator 15, a row decoder 16, a page buffer 17, and an input/output circuit 18. Although not illustrated in FIG. 1, the peripheral circuit 11 may further include an input/output interface connected to a memory controller that is an external device.

The memory cell array 12 may be connected to word lines WL, string select lines SSL, ground select lines GSL, and bit lines BL. The memory cell array 12 may be connected to the row decoder 16 through the word lines WL, the string select lines SSL, and the ground select lines GSL and be connected to the page buffer 17 through the bit lines BL and be connected to a common source line (CSL) driver (not illustrated) through common source lines (not illustrated). The memory cell array 12 includes a plurality of memory blocks BLK1 to BLKn (n is a natural number of 2 or more), each of which may include a plurality of NAND flash memory cells. The memory cell array 12 may include a three-dimensional memory cell array including a plurality of cell strings.

The three-dimensional memory cell array is formed in a monolithic type on at least one physical level of memory cell arrays, which include an active region arranged on a silicon substrate and circuitry formed on or within the silicon substrate as circuitry related to operations of memory cells. The term "monolithic" means that layers of each level constituting the array are stacked directly over layers of each lower level of the array. In embodiments according to the technical idea of the disclosure, the three-dimensional memory cell array includes cell strings arranged in a vertical detection such that at least one memory cell is over another memory cell. The at least one memory cell may include a charge trap layer. U.S. Patent No. 7,679,133, U.S. Patent No. 8,553,466, U.S. Patent No. 8,654,587, U.S. Patent No. 8,559,235, and U.S. Patent Application Publication No. 2011/0233648, describe suitable configurations for a three-dimensional memory array which is configured with multiple levels and in which word lines and/or bit lines are shared between levels.

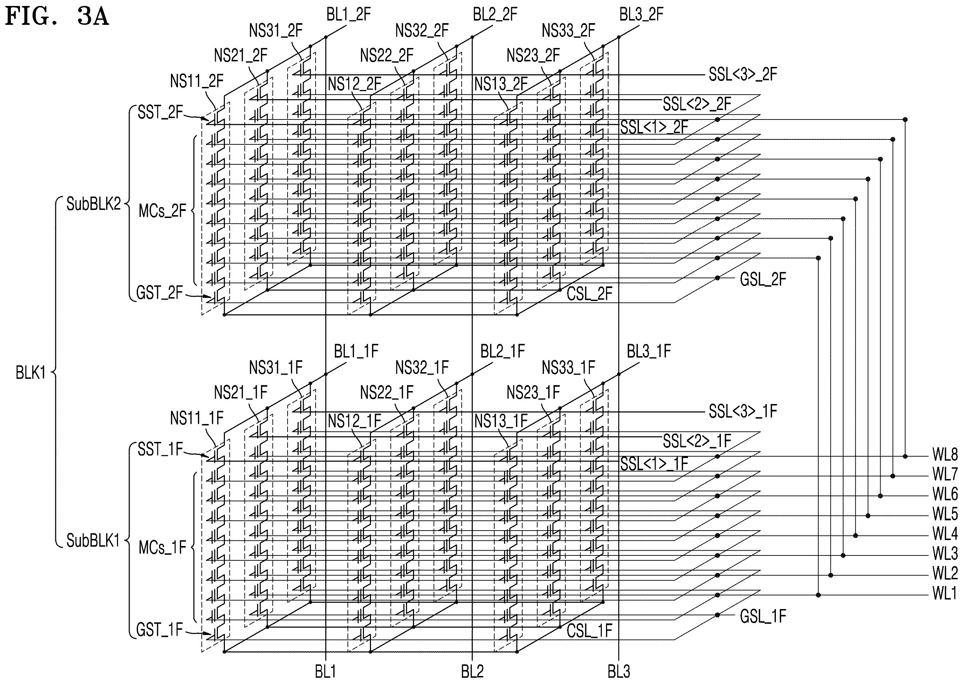

The plurality of memory blocks BLK1 to BLKn may each include a plurality of memory cells (for example, MCs_1F and MCs_2F of FIG. 3A) and a plurality of select transistors (for example, SST_1F, GST_1F, SST_2F, and GST_2F of FIG. 3A). The plurality of memory cells may be connected to the word lines WL, and the plurality of selection transistors may be connected to the string select lines SSL or the ground select lines GSL. Memory cells of each of the plurality of memory blocks BLK1 to BLKn may be configured as single-level cells storing 1-bit data or multi-level cells storing M (M is an integer of 2 or more)-bit data.

The row decoder 16 may select one of the plurality of memory blocks BLK1 to BLKn of the memory cell array 12 and drive the word lines WL, the string select lines SSL, and the ground select lines GSL of the plurality of memory blocks BLK1 to BLKn depending on operation modes (for example, program, verification, read, and erase operations).

The control logic circuit 14 may output various internal control signals for performing program, verification, read, and erase operations on the memory cell array 12 based on a command CMD, an address ADDR, and a control signal CTRL transmitted from the memory controller. The control logic circuit 14 may provide a row address R_ADDR to the row decoder 16, a column address to the input/output circuit 18, and a voltage control signal CTRL_VOL to the voltage generator 15. Accordingly, the control logic circuit 14 may control all operation modes of the memory device 10.

The page buffer 17 may operate as a write driver or a sense amplifier depending on operations of the memory device 10. During an erase operation, the page buffer 17 may drive the bit lines BL of the plurality of memory blocks BLK1 to BLKn under the control by the control logic circuit 14. During a read operation, the page buffer 17 may sense the bit lines BL of selected memory cells under the control by the control logic circuit 14. The sensed data may be stored in latches provided in the page buffer 17. The page buffer 17 may dump the data stored in the latches to the input/output circuit 18 through data lines DL under the control by the control logic circuit 14.

The input/output circuit 18 may temporarily store the command CMD, the address ADDR, and data DATA provided by a memory controller through input/output lines I/O. The input/output circuit 18 may temporarily store read data of the memory device 10 and output the read data to the outside through input/output lines I/O at a designated point in time.

The voltage generator 15 may generate various types of voltages VGEN for performing program, read, and erase operations on the memory cell array 12 based on the voltage control signal CTRL_VOL. Specifically, the voltage generator 15 may generate an erase voltage, a program voltage, a program verification voltage, a read voltage, a precharge voltage, and so on.

Referring to FIG. 2, the memory device 10 may include a cell array structure CAS and a peripheral circuit structure PCS that overlap each other in a third direction (the Z direction). The cell array structure CAS may include the memory cell array 12 described with reference to FIG. 1. The peripheral circuit structure PCS may include the peripheral circuit 11 described with reference to FIG. 1. The cell array structure CAS may include a plurality of memory blocks BLK1 to BLKn. The plurality of memory blocks BLK1 to BLKn may each include memory cells arranged in a three-dimensional manner. For example, the plurality of memory blocks BLK1 to BLKn may each include structures extending in first to third directions (the X direction to the Z direction). The plurality of memory blocks BLK1 to BLKn may each include a first sub-block SubBLK1 formed in a first cell region CELL1 and a second sub-block SubBLK2 formed in a second cell region CELL2.

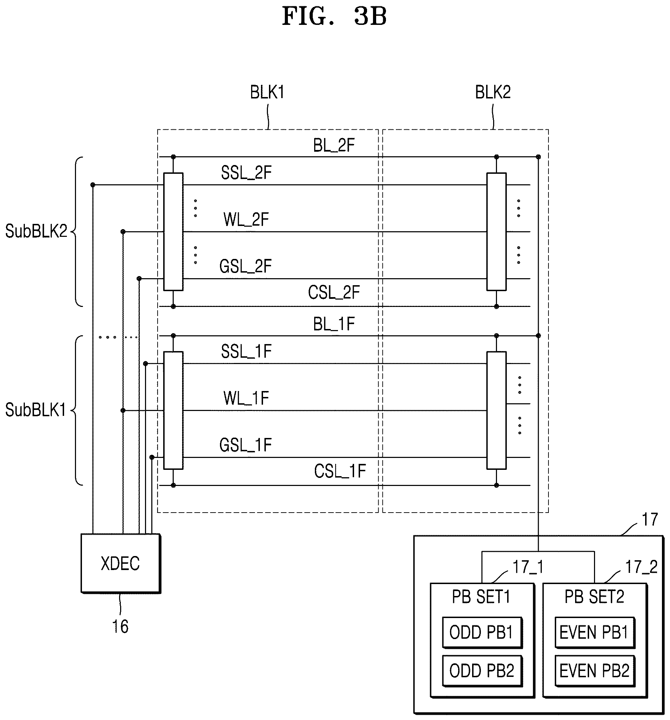

FIGS. 3A to 3C are diagrams illustrating memory blocks according to embodiments. The memory blocks illustrated in FIGS. 3A and 3B illustrate the first memory block BLK1 that is one example of the plurality of memory blocks BLK1 to BLKn described with reference to FIG. 1. Hereinafter, embodiments are described in detail using the first memory block BLK1 as an example. For the sake of convenience of description, the first memory block BLK1 may be referred to interchangeably as a memory block BLK1. The memory block BLK1 may represent a three-dimensional memory block formed in a three-dimensional structure on a substrate. A plurality of memory cell strings included in the memory block BLK1 may be formed in a direction perpendicular to the substrate. In the description made with reference to FIGS. 3A and 3B, the first memory block BLK1 is mainly described for the sake of convenience of description, and it will be understood that the second to n^{th} memory blocks BLK2 to BLKn are also configured to be identical to the first memory block BLK1.

Referring to FIG. 3A, the memory block BLK1 may include a first sub-block SubBLK1 and a second sub-block SubBLK2. Word lines WL1 to WL8 of the first sub-block SubBLK1 may be correspondingly connected to word lines WL1 to WL8 of the second sub-block SubBLK2. The first sub-block SubBLK1 may include cell strings NS11_1F to NS33_1F, the word lines WL1 to WL8, bit lines BL1_1F to BL3_1F, a ground select line GSL_1F, string select lines SSL<1>_1F to SSL<3>_1F, and a common source line CSL_1F. Although FIG. 3A illustrates that each of the cell strings NS11_1F to NS33_1F includes eight memory cells MCs_1F connected respectively to eight word lines WL1 to WL8, this is merely an example to aid understanding and is not intended to limit the disclosure.

In the first sub-block SubBLK1, a cell string (for example, NS11_1F) may each include a string select transistor SST_1F, a plurality of memory cells MCs_1F, and a ground select transistor GST_1F which are connected in series. The string select transistor SST_1F is connected to the string select line SSL<1>_1F corresponding thereto. The plurality of memory cells MCs_1F are respectively connected to the word lines WL1 to WL8. The ground select transistor GST_1F is connected to the ground select line GSL_1F. The string select transistor SST_1F is connected to the bit line BL1_1F corresponding thereto, and the ground select transistor GST_1F is connected to the common source line CSL_1F.

In the first sub-block SubBLK1, the word lines WL1 to WL8 are each commonly connected to the memory cell transistors included in one layer. The memory cell transistors included in one layer receive the same word line voltage. A plurality of string select transistors SST_1F formed in one layer are connected to the plurality of string select lines SSL<1>_1F to SSL<3>_1F. Ground select transistors GST_1F are controlled simultaneously. That is, the ground select transistors GST_1F included in the first sub-block SubBLK1 are controlled by the ground select line GSL_1F.

In embodiments, the string select line SSL<1>_1F of the first sub-block SubBLK1 may be composed of multiple string select lines, and the ground select line GSL_1F may also be composed of multiple ground select lines.

In the same manner as the first sub-block SubBLK1, the second sub-block SubBLK2 may each include a string select transistor SST_2F, a plurality of memory cells MCs_2F, and a ground select transistor GST_2F which are connected in series. The string select transistor SST_2F is connected to the string select line SSL<1>_2F corresponding thereto, the plurality of memory cells MCs_2F are respectively connected to the word lines WL1 to WL8, and the ground select transistor GST_2F is connected to the ground select line GSL_2F. The string select transistor SST_2F is connected to the bit line BL1_2F corresponding thereto, and the ground select transistor GST_2F is connected to the common source line CSL_2F. The string select line SSL<1> _2F of the second sub-block SubBLK2 may be composed of a plurality of string select lines, and the ground select line GSL_2F may also be composed of a plurality of ground select lines.

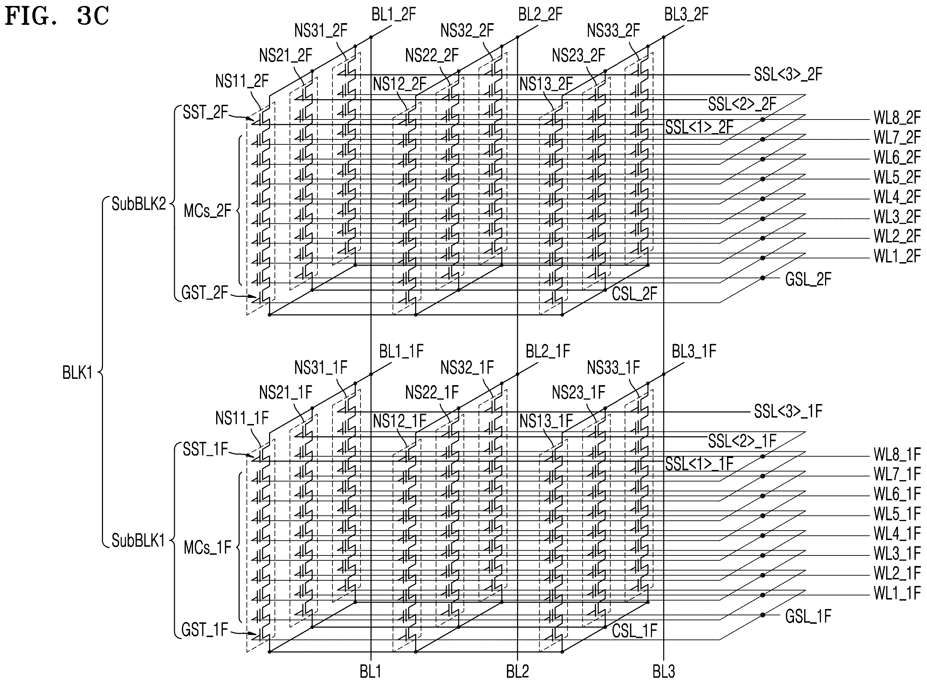

Referring to FIG. 3B, the first memory block BLK1 and the second memory block BLK2 may each include the first sub-block SubBLK1 and the second sub-block SubBLK2. Word lines WL_1F of the first sub-blocks SubBLK1 of the first memory block BLK1 and the second memory block BLK2 and word lines WL_2F of the second sub-blocks SubBLK2 thereof may be correspondingly connected to each other and commonly connected to the row decoder 16. For example, referring also to FIG. 3C, word lines WL1_1F to WL8_1F connected to the first sub-block SubBLK1 may be independently controlled from word lines WL1_2F to WL8_2F connected to the second sub-block SubBLK2. The string select lines SSL_1F of the first sub-block SubBLK1 of each of the first memory block BLK1 and the second memory block BLK2 and the string select lines SSL_2F of the second sub-block SubBLK2 may be connected to the row decoder 16. The ground select lines GSL_1F of the first sub-block SubBLK1 of each of the first memory block BLK1 and the second memory block BLK2 and the ground select lines GSL_2F of the second sub-block SubBLK2 of each of the first memory block BLK1 and the second memory block BLK2 may be connected to the row decoder 16.

A bit line BL_1F of the first sub-block SubBLK1 of each of the first memory block BLK1 and the second memory block BLK2 and a bit line BL_2F of the second sub-block SubBLK2 of each of the first memory block BLK1 and the second memory block BLK2 may be connected to the page buffer 17. The page buffer 17 connected to the bit lines BL1, BL2, and BL3 may drive bit lines BL1_1F, BL2_1F, and BL3_1F of the first sub-block SubBLK1 and bit lines BL1_2F, BL2_2F, and BL3_2F of the second sub-block SubBLK2.

In embodiments, the page buffer 17 may include a first page buffer set 17_1 and a second page buffer set 17_2. The first page buffer set 17_1 may include a first odd page buffer ODD PB1 and a second odd page buffer ODD PB2. The second page buffer set 17_2 may include a first even page buffer EVEN PB1 and a second even page buffer EVEN PB2.

Bit lines BL_2F of the second sub-block SubBLK2 and Bit lines BL_1F of the first sub-block SubBLK1 may be asymmetrically connected to the page buffer 17. For example, referring to FIGS. 3A and 3B together, the first bit line BL1_2F of the second sub-block SubBLK2 may be connected to the first odd page buffer ODD PB1 of the first page buffer set 17_1, and the second bit line BL2_2F adjacent to the first bit line BL1_2F of the second sub-block SubBLK2 may be connected to the second even page buffer EVEN PB2 of the second page buffer set 17_2. The first bit line BL1_1F of the first sub-block SubBLK1 may be connected to the first even page buffer EVEN PB1 of the first page buffer set 17_1, and the second bit line BL2_1F adjacent to the first bit line BL1_1F of the first sub-block SubBLK1 may be connected to the second odd page buffer ODD PB2 of the second page buffer set 17_2. That is, an asymmetrical connection between bit lines and a page buffer may refer to bit lines (for example, the first bit line BL1_1F, and the second bit line BL2_1F) of the same sub-block (for example, the first sub-block SubBLK1) being connected to different page buffers. A detailed description of the asymmetric connection between the bit lines and the page buffer is made below.

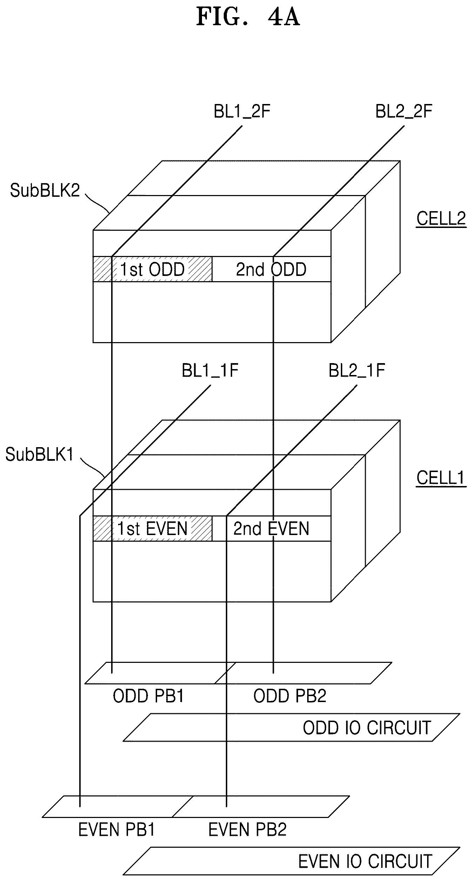

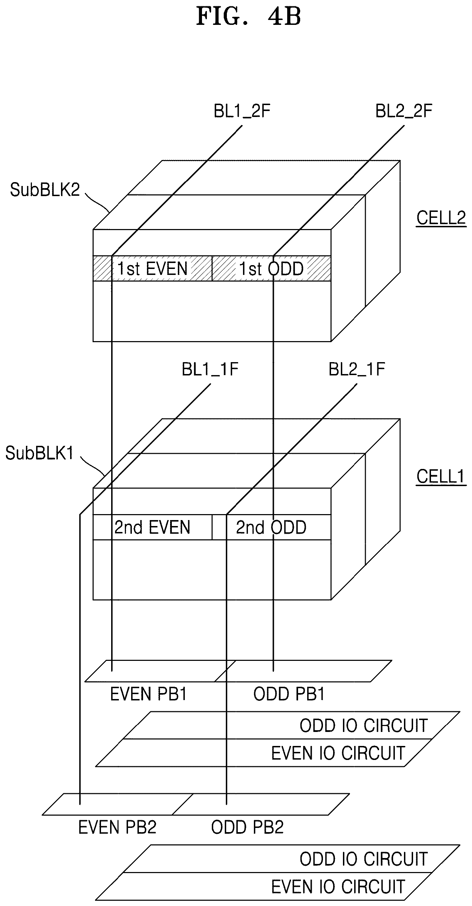

FIGS. 4A and 4B illustrate connections between the page buffer 17 and bit lines, according to comparative examples.

Referring to FIG. 4A, the first sub-block SubBLK1 and the second sub-block SubBLK2 are symmetrically connected to the page buffer 17. For example, the bit lines BL1_2F and BL2_2F of the second sub-block SubBLK2 may be connected to a page buffer set for processing odd data from odd-numbered bit lines. The bit lines BL1_1F and BL2_1F of the first sub-block SubBLK1 may be connected to a page buffer set for processing even data from even-numbered bit lines.

For example, depending on applications, 4KB and 8KB reads may be used in some situations, such as 16KB sequential read and random read. Word lines of NAND flash memory are structured to be separated into 8K units, but for area reduction and IO performance, data is stored separately in 8K word lines for odd data and 8K word lines for even data. For example, even data may be stored in the first cell region CELL1, and odd data may be stored in the second cell region CELL2. For example, odd data (hereinafter, first odd data) of the first data and odd data (hereinafter, second odd data) of the second data may be stored in the second sub-block SubBLK2 of the second cell region CELL2. Even data (hereinafter, first even data) of the first data and even data (hereinafter, second odd data) of the second data may be stored in the second sub-block SubBLK2 of the second cell region CELL2.

Accordingly, to perform an 8K data read according to the comparative example, the first data read may include the first even data read and the first odd data read. Because word lines of both the first cell region CELL1 and the second cell region CELL2 have to be precharged for the first even data read and the first odd data read, the same power as in 16K data read be consumed inevitably although the read is an 8K data read.

Referring to FIG. 4B according to the comparative example, to prevent the same power as in the 16K read from being consumed during the 8K read, the second cell region CELL2 may also store data. For example, the first even data and the first odd data may also be stored in the second cell region CELL2, and the second even data and the second odd data may also be stored in the first cell region CELL1. However, a page buffer (for example, 17 in FIG. 1) has to include an even IO circuit (or an even prefetch circuit) for processing the first even data output from the first bit line BL1_2F of the second sub-block SubBLK2, and has to include an odd IO circuit (or an odd prefetch circuit) for processing the first odd data output from the second bit line BL2_2F of the second sub-block SubBLK2. That is, IO circuits (or a prefetch circuit) for respectively processing even data and odd data are required twice as many, and accordingly, there is a disadvantage of increasing an area.

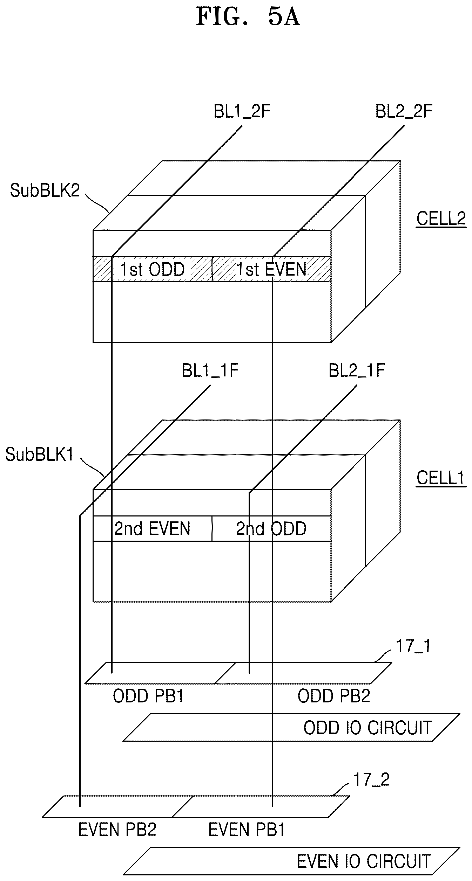

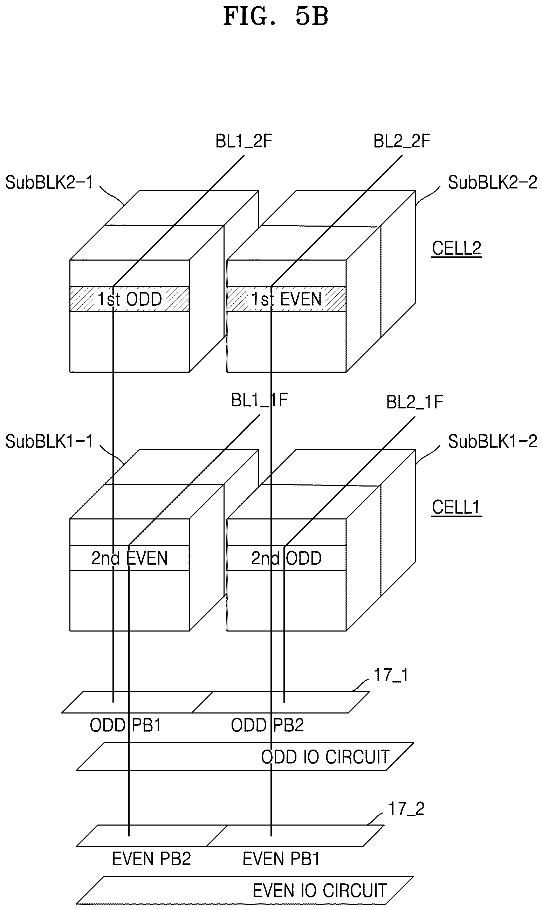

FIGS. 5A and 5B illustrate connections between the page buffer 17 and bit lines, according to embodiments.

Referring to FIG. 5A, the second sub-block SubBLK2 may store first data. For example, the second sub-block SubBLK2 may store first odd data 1st ODD and first even data 1st EVEN. To read the first data of 8 KB, by precharging only the word lines (or all bit lines (ABLs)) of the second sub-block SubBLK2, 8KB read may be performed with less power than 16KB read.

To this end, the first sub-block SubBLK1 and the second sub-block SubBLK2 may be connected asymmetrically and respectively to the first page buffer set 17_1 and the second page buffer set 17_2. The first page buffer set 17_1 may include a first odd page buffer ODD PB1 and a second odd page buffer ODD PB2 connected to an odd IO circuit (or an odd prefetch circuit). The second page buffer set 17_2 may include a first even page buffer EVEN PB1 and a second even page buffer EVEN PB2 connected to an even IO circuit (or an even prefetch circuit).

Depending on embodiments, asymmetrical connections between bit lines and a page buffer may refer to connections between bit lines in the same cell region and different page buffer sets. For example, the first bit line BL1_2F transmitting the first odd data 1st ODD of the second cell region CELL2 may be connected to the first odd page buffer ODD PB1 of the first page buffer set 17_1. The second bit line BL2_2F transmitting the first even data 1st EVEN of the second cell region CELL2 may be connected to the first even page buffer EVEN PB1 of the second page buffer set 17_2.

In the first cell region CELL1, bit lines may be asymmetrically connected to the page buffer, similarly to the second cell region CELL2. For example, the second bit line BL2_1F transmitting second odd data 2nd ODD of the first cell region CELL1 may be connected to the second odd page buffer ODD PB2 of the first page buffer set 17_1. The first bit line BL1_1F transmitting second even data 2nd EVEN in the first cell region CELL1 may be connected to the second even page buffer EVEN PB2 of the second page buffer set 17_2.

Referring to FIG. 5B, the first sub-block SubBLK1 and the second sub-block SubBLK2 may each be divided based on a word line size. For example, based on word lines of 4K units, the first sub-block SubBLK1 may be divided into a first-1 sub-block SubBLK1-1 and a first-2 sub-block SubBLK1-2. The second sub-block SubBLK2 may be divided into a second-1 sub-block SubBLK2-1 and a second-2 sub-block SubBLK2-2. Even in a structure divided according to sizes of word lines, sub-blocks (for example, SubBLK1-1 to SubBLK2-2) may be connected asymmetrically to a page buffer.

For example, the first bit line BL1_2F, which transmits the first odd data 1st ODD of the second-1 sub-block SubBLK2-1, may be connected to the first odd page buffer ODD PB1 of the first page buffer set 17_1. The second bit line BL2_2F, which transmits the first even data 1st EVEN of the second-2 sub-block SubBLK2-2, may be connected to the first even page buffer EVEN PB1 of the second page buffer set 17_2.

The first cell region CELL1 may be asymmetrically connected to a page buffer, similarly to the second cell region CELL2. For example, the second bit line BL2_1F, which transmits the second odd data 2nd ODD of the first-2 sub-block SubBLK1-2, may be connected to the second odd page buffer ODD PB2 of the first page buffer set 17_1. The first bit line BL1_1F, which transmits the second even data 2nd EVEN of the first-1 sub-block SubBLK1-1, may be connected to the second even page buffer EVEN PB2 of the second page buffer set 17_2.

As described above, by asymmetrically connecting bit lines to a page buffer, only the word line of one cell region (CELL1 or CELL2) may be precharged to perform a read operation during 8KB data read.

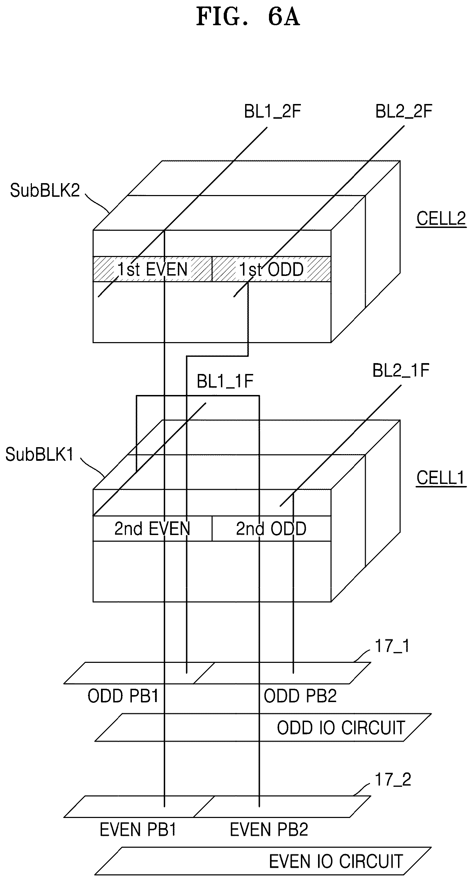

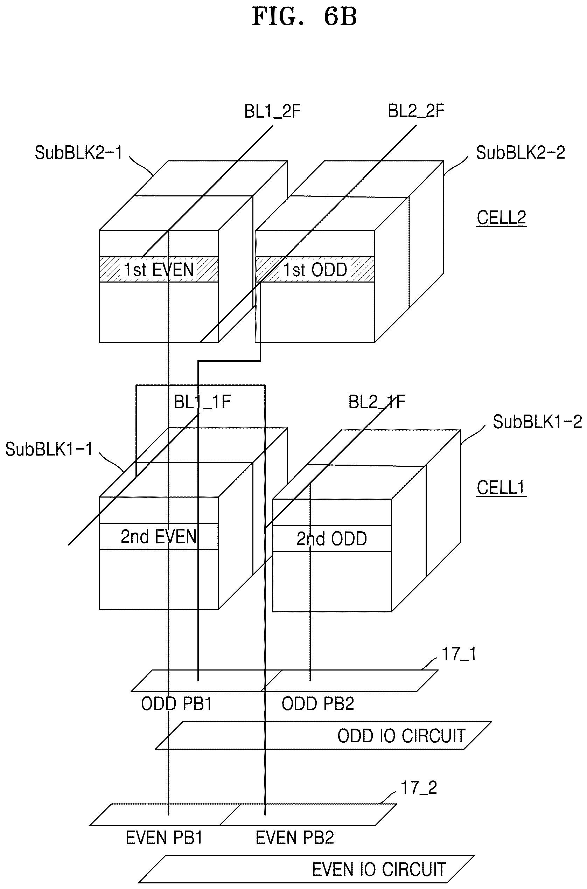

FIGS. 6A and 6B illustrate connections between the page buffer 17 and bit lines, according to embodiments.

Referring to FIG. 6A, the second sub-block SubBLK2 may store first data. For example, the second sub-block SubBLK2 may store the first odd data 1st ODD and the first even data 1st EVEN. To read the first data of 8 KB, only the word lines of the second sub-block SubBLK2 may be precharged, and accordingly, 8KB read may be performed with less power than 16KB read. To achieve this, the first sub-block SubBLK1 and the second sub-block SubBLK2 may be asymmetrically connected to the first page buffer set 17_1 and the second page buffer set 17_2. For example, the second bit line BL2_2F of the second sub-block SubBLK2, which transmits the first odd data 1st ODD, may be connected to the first odd page buffer ODD PB1 of the first page buffer set 17_1. The first bit line BL1_2F of the second sub-block SubBLK2, which transmits the first even data 1st EVEN, may be connected to the first even page buffer EVEN PB1 of the second page buffer set 17_2.

The first cell region CELL1 may be asymmetrically connected to the page buffer, similarly to the second cell region CELL. For example, the second bit line BL2_1F of the first sub-block SubBLK1, which transmits the second odd data 2nd ODD, may be connected to the second odd page buffer ODD PB2 of the first page buffer set 17_1. The first bit line BL1_1F of the first sub-block SubBLK1, which transmits the second even data 2nd EVEN, may be connected to the second even page buffer EVEN PB2 of the second page buffer set 17_2.

Referring to FIG. 6B, the first sub-block SubBLK1 and the second sub-block SubBLK2 may each be divided based on a word line size. For example, based on word lines of 4K units, the first sub-block SubBLK1 may be divided into a first-1 sub-block SubBLK1-1 and a first-2 sub-block SubBLK1-2. The second sub-block SubBLK2 may be divided into a second-1 sub-block SubBLK2-1 and a second-2 sub-block SubBLK2-2. Even in a structure divided according to sizes of word lines, sub-blocks (for example, SubBLK1-1 to SubBLK2-2) may be connected asymmetrically to a page buffer.

For example, the first bit line BL1_2F of the second-1 sub-block SubBLK2-1, which transmits the first even data 1st EVEN, may be connected to the first even page buffer EVEN PB1 of the second page buffer set 17_2. The second bit line BL2_2F of the second-2 sub-block SubBLK2-2, which transmits the first odd data 1st ODD, may be connected to the first odd page buffer ODD PB1 of the first page buffer set 17_1.

The first cell region CELL1 may be asymmetrically connected to a page buffer, similarly to the second cell region CELL2. For example, the second bit line BL2_1F of the first-2 sub-block SubBLK1-2, which transmits the second odd data 2nd ODD, may be connected to the second odd page buffer ODD PB2 of the first page buffer set 17_1. The first bit line BL1_1F of the first-1 sub-block SubBLK1-1, which transmits the second even data 2nd EVEN, may be connected to the second even page buffer EVEN PB2 of the second page buffer set 17_2.

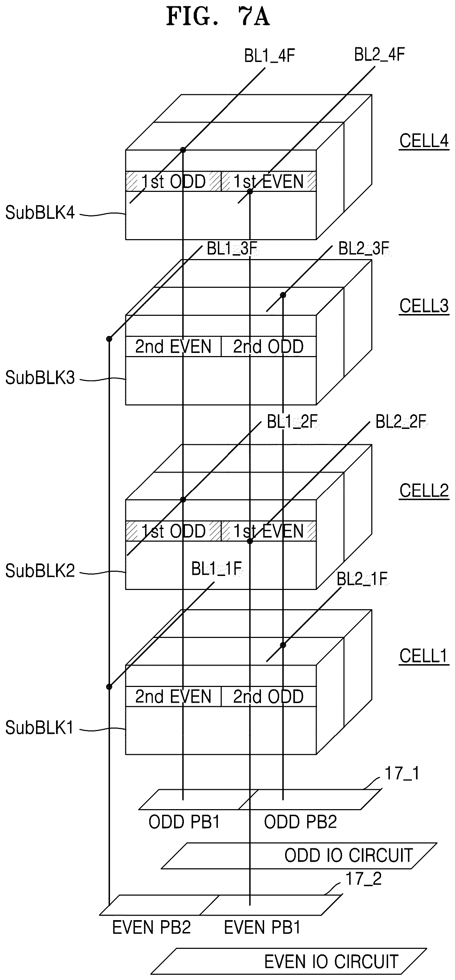

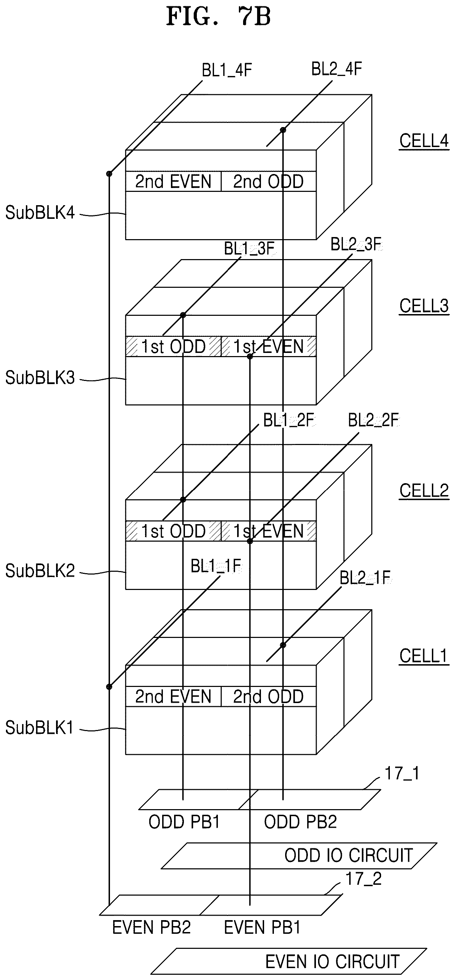

FIGS. 7A and 7B illustrate other examples of connections between the page buffer 17 and bit lines, according to embodiments.

Referring to FIGS. 7A and 7B, a plurality of blocks BLK1 to BLKn may each include four sub-blocks. For example, a memory device may include four upper chips, and the four upper chips may include a first upper chip including a first cell region CELL1, a second upper chip including a second cell region CELL2, a third upper chip including a third cell region CELL3, and a fourth upper chip including a fourth cell region CELL4.

Referring to FIG. 7A, each of the first to fourth upper chips may alternately output the same data. For example, the first cell region CELL1 of the first upper chip and the third cell region CELL3 of the third upper chip may store second data. A first sub-block SubBLK1 and a third sub-block SubBLK3 may each output second even data and second odd data constituting the second data. The second cell region CELL2 of the second upper chip and the fourth cell region CELL4 of the fourth upper chip may each store first data. A second sub-block SubBLK2 and a fourth sub-block SubBLK4 may each output first even data and first odd data constituting the first data.

According to embodiments, the first sub-block SubBLK1 and the second sub-block SubBLK2 may be asymmetrically connected to a first page buffer set 17_1 and a second page buffer set 17_2. For example, the first bit line BL1_2F,which transmits first odd data 1st ODD of the second cell region CELL2, may be connected to a first odd page buffer ODD PB1 of the first page buffer set 17_1. The second bit line BL2_2F, which transmits first even data 1st EVEN of the second cell region CELL2, may be connected to a first even page buffer EVEN PB1 of the second page buffer set 17_2.

According to embodiments, the fourth sub-block SubBLK4 may be matched to the second sub-block SubBLK2 of the second cell region CELL2 and be connected to the same page buffer as the second sub-block SubBLK2. For example, the first bit line BL1_4F, which transmits the first odd data 1st ODD of the fourth cell region CELL4, may be connected to the first bit line BL1_2F of the second cell region CELL2 and be connected to the first odd page buffer ODD PB1 of the first page buffer set 17_1. The second bit line BL2_4F, which transmits first even data 1st EVEN of the fourth cell region CELL4, may be connected to the second bit line BL2_2F of the second cell region CELL2 and be connected to the first even page buffer EVEN PB1 of the second page buffer set 17_2.

The first cell region CELL1 may be asymmetrically connected to a page buffer, similarly to the second cell region CELL2. For example, the second bit line BL2_1F, which transmits the second odd data 2nd ODD of the first cell region CELL1, may be connected to a second odd page buffer ODD PB2 of the first page buffer set 17_1. The first bit line BL1_1F, which transmits the second even data 2nd EVEN of the first cell region CELL1, may be connected to a second even page buffer EVEN PB2 of the second page buffer set 17_2.

According to embodiments, the third sub-block SubBLK3 may be matched to the first sub-block SubBLK1 of the first cell region CELL1 and be connected to the same page buffer as the first sub-block SubBLK1. For example, the second bit line BL2_3F, which transmits second odd data 2nd ODD of the third cell region CELL3, may be connected to the second bit line BL2_1F of the first cell region CELL1 and be connected to the second odd page buffer ODD PB2 of the first page buffer set 17_1. The first bit line BL1_3F, which transmits second even data 2nd EVEN of the third cell region CELL3, may be connected to the first bit line BL1_1F of the first cell region CELL1 and be connected to the second even page buffer EVEN PB2 of the second page buffer set 17_2.

Referring to FIG. 7B, first to fourth upper chips may also be matched such that two chips which are most distant from each other output the same data and two chips which are most adjacent to each other output the same data. For example, when the two most distant chips are matched to each other, the first cell region CELL1 of the first upper chip and the fourth cell region CELL4 of the fourth upper chip may output the second data. For another example, when the two most adjacent chips are matched to each other, the second cell region CELL2 of the second upper chip and the third cell region CELL3 of the third upper chip may output the first data.

According to embodiments, a first sub-block SubBLK1 and a second sub-block SubBLK2 may be asymmetrically connected to the first page buffer set 17_1 and the second page buffer set 17_2. For example, the first bit line BL1_2F, which transmits first odd data 1st ODD of the second cell region CELL2, may be connected to first odd page buffer ODD PB1 of a first page buffer set 17_1. The second bit line BL2_2F, which transmits first even data 1st EVEN of the second cell region CELL2, may be connected to a first even page buffer EVEN PB1 of a second page buffer set 17_2.

According to embodiments, the third sub-block SubBLK3 may be matched to the second sub-block SubBLK2 of the second cell region CELL2 and be connected to the same page buffer as the second sub-block SubBLK2. For example, the first bit line BL1_3F, which transmits first odd data 1st ODD of the third cell region CELL3, may be connected to the first bit line BL1_2F of the second cell region CELL2 and be connected to the first odd page buffer ODD PB1 of the first page buffer set 17_1. The second bit line BL2 _3F, which transmits first even data 1st EVEN of the third cell region CELL3, may be connected to the second bit line BL2_2F of the second cell region CELL2 and be connected to the first even page buffer EVEN PB1 of the second page buffer set 17_2.

The first cell region CELL1 may be asymmetrically connected to a page buffer, similarly to the second cell region CELL2. For example, the second bit line BL2_1F, which transmits second odd data 2nd ODD of the first cell region CELL1 may be connected to the second odd page buffer ODD PB2 of the first page buffer set 17_1. The first bit line BL1_1F, which transmits second even data 2nd EVEN of the first cell region CELL1 may be connected to the second even page buffer EVEN PB2 of the second page buffer set 17_2.

According to embodiments, the fourth sub-block SubBLK4 may be matched to the first sub-block SubBLK1 of the first cell region CELL1 and be connected to the same page buffer as the first sub-block SubBLK1. For example, the second bit line BL2_4F, which transmits second odd data 2nd ODD of the fourth cell region CELL4, may be connected to the second bit line BL2_1F of the first cell region CELL1 and be connected to the second odd page buffer ODD PB2 of the first page buffer set 17_1. The first bit line BL1_4F, which transmits second even data 2nd EVEN of the fourth cell region CELL4 may be connected to the first bit line BL1_1F of the first cell region CELL1 and be connected to the second even page buffer EVEN PB2 of the second page buffer set 17_2.

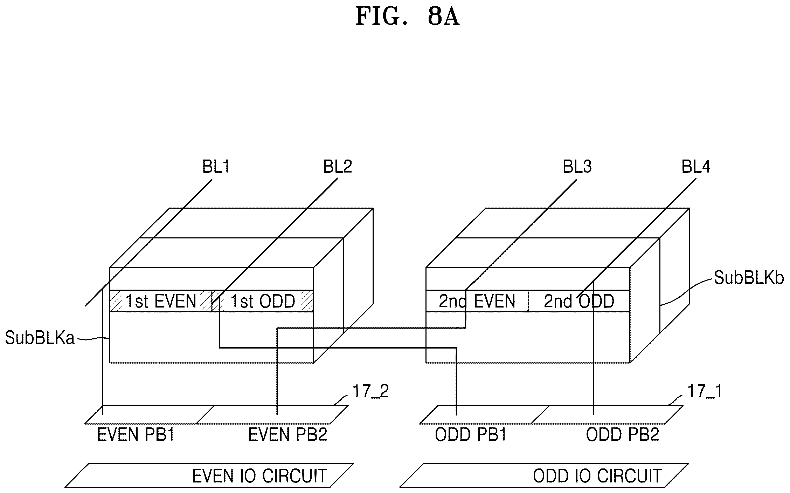

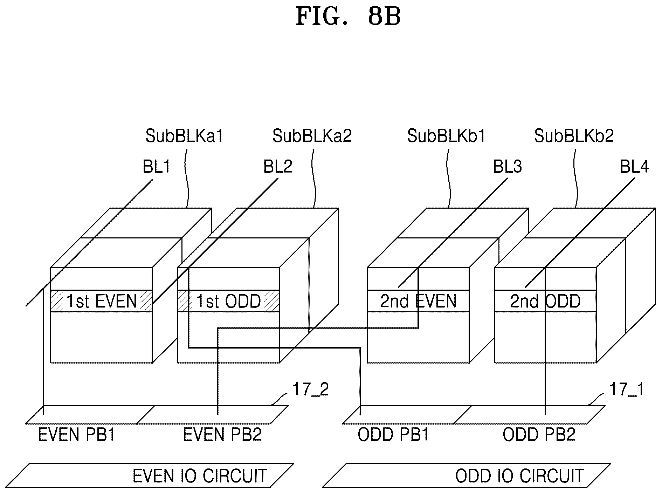

FIGS. 8A and 8B illustrate other examples of connections between the page buffer 17 and bit lines, according to embodiments.

Referring to FIG. 8A, a first sub-block SubBLKa may be adjacent to a second sub-block SubBLKb in a first direction (for example, the X direction of FIG. 2).

The first sub-block SubBLKa may store first data. For example, the first sub-block SubBLKa may store first odd data 1st ODD and first even data 1st EVEN. To read the first data of 8 KB, by precharging only word lines of the first sub-block SubBLKa, 8KB read may be performed with less power than 16KB read.

To this end, the first sub-block SubBLKa and the second sub-block SubBLKb may be asymmetrically connected to the first page buffer set 17_1 and the second page buffer set 17_2. An asymmetrical connection may refer to a connection of different bit lines to different page buffer sets in the same sub-block. For example, a second bit line BL2, which transmits the first odd data 1st ODD of the first sub-block SubBLKa, may be connected to a first odd page buffer ODD PB1 of the first page buffer set 17_1. A first bit line BL1, which transmits the first even data 1st EVEN of the first sub-block SubBLKa, may be connected to a first even page buffer EVEN PB1 of the second page buffer set 17_2. A fourth bit line BL4, which transmits second odd data 2nd ODD of the second sub-block SubBLKb, may be connected to a second odd page buffer ODD PB2 of the first page buffer set 17_1. A third bit line BL3, which transmits second even data 2nd EVEN of the second sub-block SubBLKb, may be connected to a second even page buffer EVEN PB2 of the second page buffer set 17_2.

Referring to FIG. 8B, a first sub-block SubBLKa and a second sub-block SubBLKb may each be divided based on a word line size. For example, based on word lines of 4K units, the first sub-block SubBLKa may be divided into a first-1 sub-block SubBLKa1 and a first-2 sub-block SubBLKa2. The second sub-block SubBLKb may be divided into a second-1 sub-block SubBLKb1 and a second-2 sub-block SubBLKb2. Even in a structure divided according to the word line size, sub-blocks (for example, SubBLKa1 to SubBLKb2) may be asymmetrically connected to a page buffer.

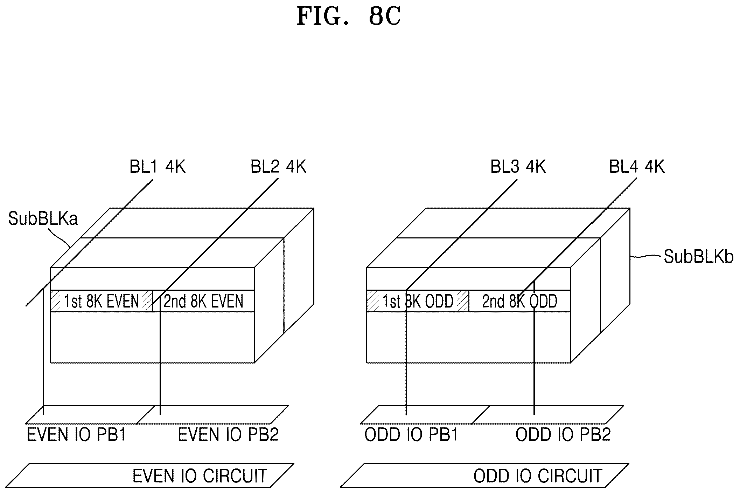

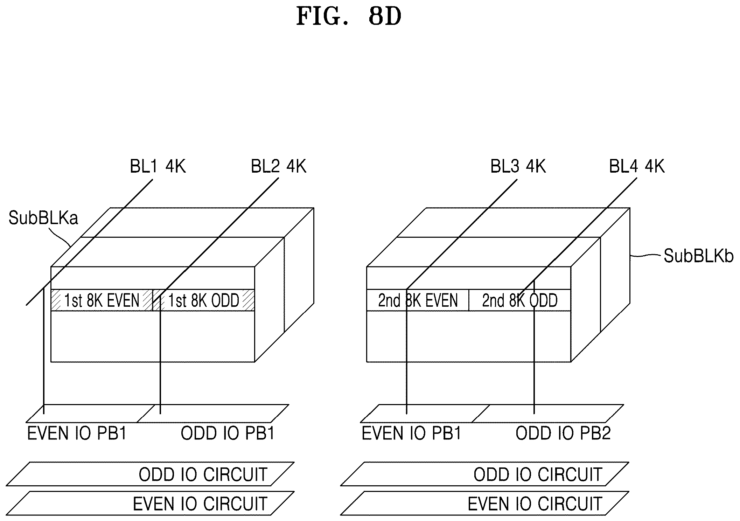

FIGS. 8C and 8D illustrate connection between the page buffer 17 and bit lines, according to comparative examples.

Referring to FIG. 8C, a first sub-block SubBLKa and a second sub-block SubBLKb may be adjacent sub-blocks in a first direction (for example, the X direction in FIG. 2).

The first sub-block SubBLKa may store only even data, and the second sub-block SubBLKb may store only odd data. For example, the first sub-block SubBLKa may store first even data 1st EVEN and second even data 2nd EVEN. The second sub-block SubBLKb may store first odd data 1st ODD and second odd data 2nd ODD.

According to the comparative examples, word lines of both the first sub-block SubBLKa and the second sub-block SubBLKb have to be precharged to read first data (that is, the first odd data 1st ODD and the first even data 1st EVEN). That is, in reading the first data according to the comparative example, a problem still arises that the same amount of power is consumed during 16KB read and 8KB read.

To solve the problem that the same amount of power is consumed during 16KB read and 8KB read, that is, to prevent the same amount of power from being consumed during the 16KB read and the 8KB read, data may also be stored in a single sub-block instead of being stored separately in different sub-blocks. For example, referring to FIG. 8D, a first sub-block SubBLKa may store first data. For example, the first sub-block SubBLKa may store first odd data 1st ODD and first even data 1st EVEN. By precharging only word lines of a first sub-block SubBLKa to read the first data of 8 KB, 8KB read may be performed with less power than 16KB read. However, similarly to FIG. 4B, a page buffer (for example, 17 in FIG. 1) has to include an even IO circuit (or an even prefetch circuit) for processing the first even data output from a first bit line BL1 of the first sub-block SubBLKa, and also has to include an odd IO circuit (or an odd prefetch circuit) for processing the first odd data output from a second bit line BL2 of the first sub-block SubBLKa. That is, there is a disadvantage in that an area increases because twice as many IO circuits (or prefetch circuits) are required to process both the even data and the odd data.

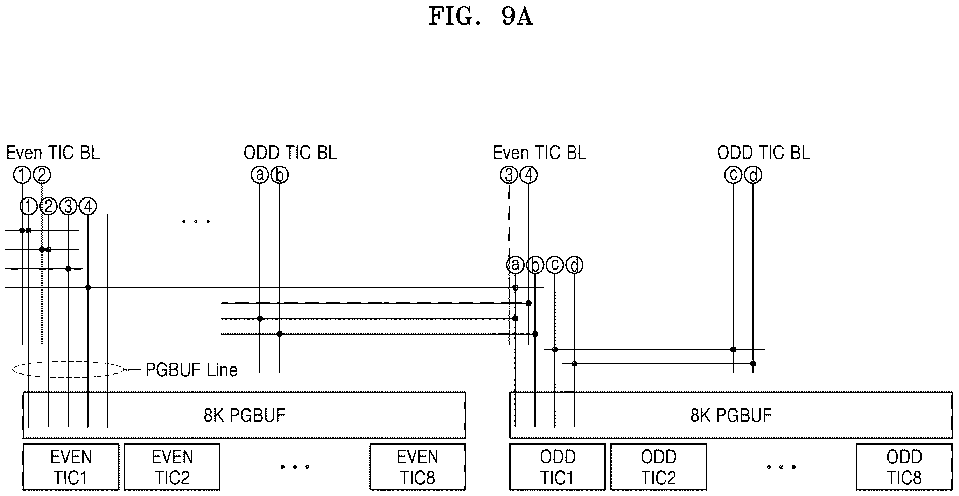

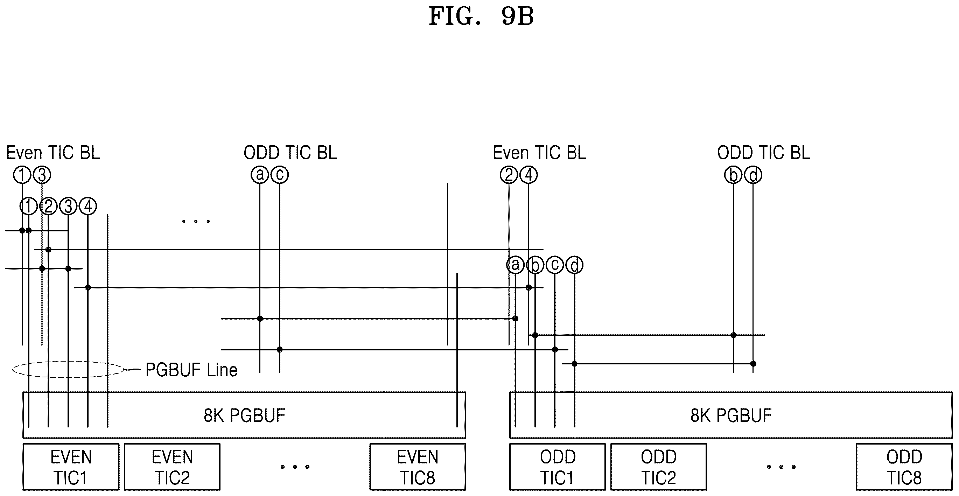

FIGS. 9A and 9B illustrate examples of connections between bit lines, according to embodiments.

Referring to FIG. 9A, even bit lines ① to ④ and odd bit lines ⓐ to ⓓ are illustrated.

Referring to FIG. 8B together, first even bit lines ① and ③ among the even bit lines ① to ④ may correspond to the first bit line BL1 which transmits the first even data 1st EVEN of the first-1 sub-block SubBLKa1. Referring to FIG. 8B together, second even bit lines ② and (4) among the even bit lines ① to ④ may correspond to the third bit line BL3 which transmits the second even data 2nd EVEN of the second-1 sub-block SubBLKb1.

Referring to FIG. 8B together, first odd bit lines ⓐ and ② among the odd bit lines ⓐ to ⓓ may correspond to the second bit line BL2 which transmits the first odd data 1st ODD of the first-2 sub-block SubBLKa2. Second odd bit lines ⓑ and ⓓ among the odd bit lines ⓐ to ⓓ may correspond to the fourth bit line BL4 which transmits the second odd data 2nd ODD of the second-2 sub-block SubBLKb2.

Referring to FIG. 9A, adjacent bit lines may be grouped together. For example, the even bit lines ① and ② for the first even data may be adjacent to each other. The odd bit lines ⓐ and ⓑ for the first odd data may be adjacent to each other. Accordingly, by grouping adjacent bit lines, occupation of lower layer horizontal wires may be reduced.

Referring to FIG. 9B, alternating bit lines may be grouped together. For example, the even bit lines ① and ③ for the first even data may not be adjacent but may alternate with each other at a certain interval. The odd bit lines ⓐ and ⓒ for the first odd data may also alternate with each other. When alternating bit lines are mapped, bit line capacitances of the lower layer horizontal wires may be reduced, and by using thicker lower layer horizontal wires, resistances of bit lines may be reduced, and because the shape of a page buffer may be freely set, the number of page buffers and sizes thereof are not restricted.

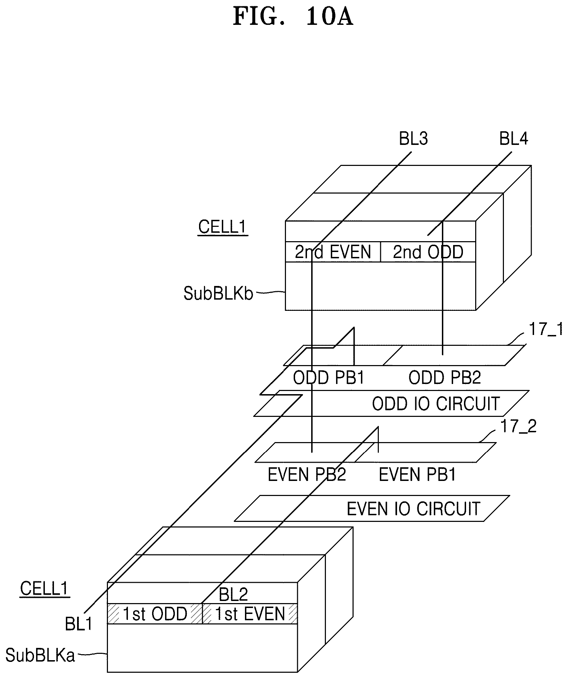

FIGS. 10A to 10C illustrate other examples of a connection between the page buffer 17 and bit lines, according to embodiments.

Referring to FIG. 10a, a first sub-block SubBLKa may be adjacent to a second sub-block SubBLKb in the Y direction (for example, the Y axis in FIG. 2). That is, referring to FIG. 2 together, when the first sub-block SubBLKa corresponds to the first cell region CELL1 of the first memory block BLK1, the second sub-block SubBLKb may correspond to the first cell region CELL1 of the second memory block BLK2.

The first sub-block SubBLKa may store first data. For example, the first sub-block SubBLKa may store first odd data 1st ODD and first even data 1st EVEN. To read first data of 8 KB, by precharging only word lines of the first sub-block SubBLKa, 8KB read may be performed with less power than 16KB read.

To this end, the first sub-block SubBLKa and the second sub-block SubBLKb may be asymmetrically connected to the first page buffer set 17_1 and the second page buffer set 17_2. In this case, the first sub-block SubBLKa may be connected to a page buffer by routing bit lines in the positive Y direction, and the second sub-block SubBLKb may be connected to the page buffer by routing bit lines in the negative Y direction.

For example, the first bit line BL1, which transmits the first odd data 1st ODD of the first sub-block SubBLKa, may be connected to a first odd page buffer ODD PB1 of the first page buffer set 17_1. The second bit line BL2, which transmits the first even data 1st EVEN of the first sub-block SubBLKa, may be connected to a first even page buffer EVEN PB1 of the second page buffer set 17_2. The fourth bit line BL4, which transmits the second odd data 2nd ODD of the second sub-block SubBLKb, may be connected to a second odd page buffer ODD PB2 of the first page buffer set 17_1. The third bit line BL3, which transmits the second even data 2nd EVEN of the second sub-block SubBLKb, may be connected to a second even page buffer EVEN PB2 of the second page buffer set 17_2.

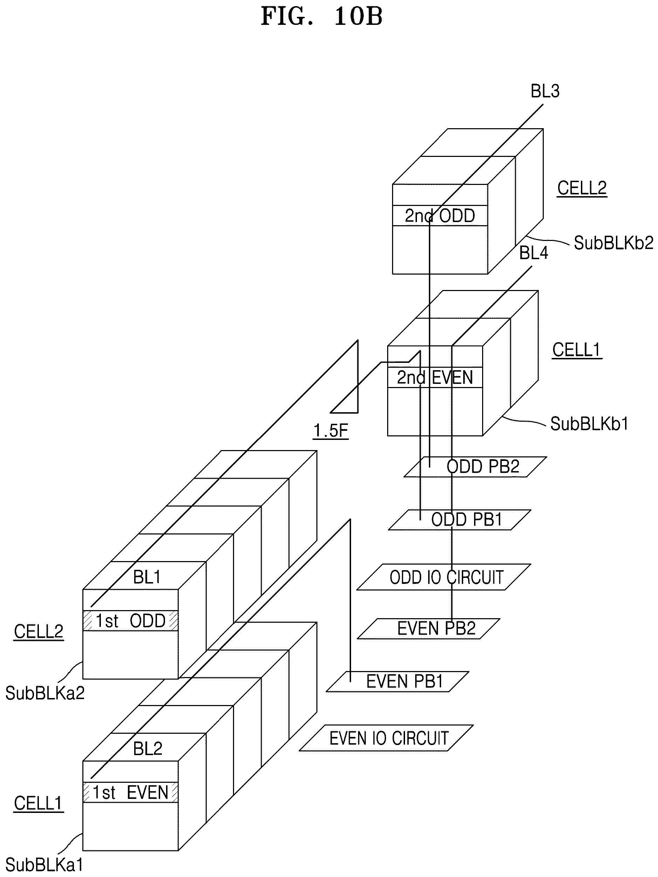

Referring to FIG. 10B, the first sub-block SubBLKa and the second sub-block SubBLKb may each be divided into word lines of 4K units, and the divided sub-blocks may be in different upper chips. For example, the first sub-block SubBLKa may be divided into a first-1 sub-block SubBLKa1 in the first cell region CELL1 and a first-2 sub-block SubBLKa2 in the second cell region CELL2 above the first cell region CELL1, based on 4K units. The second sub-block SubBLKb may be divided into a second-1 sub-block SubBLKb1 in the first cell region CELL1 and a second-2 sub-block SubBLKb2 in the second cell region CELL2 above the first cell region CELL1, based on 4K units. According to embodiments, a plurality of sub-blocks SubBLKa1 to SubBLKb2 may be asymmetrically connected to a page buffer.

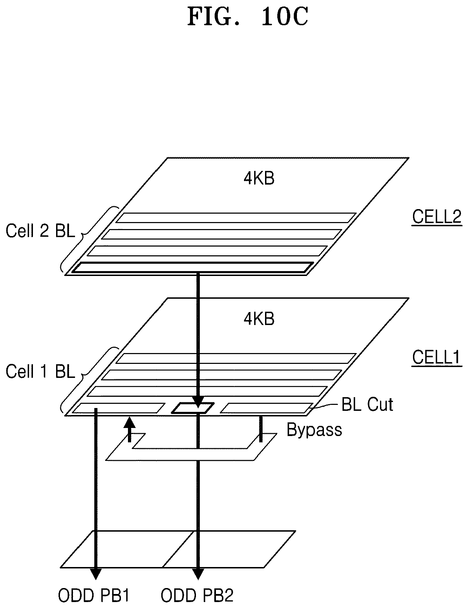

Referring also to FIG. 10C, a bit line corresponding to the first-2 sub-block SubBLKa2 in FIG. 10B may be routed and connected to a first odd page buffer ODD PB1. For example, the bit line corresponding to the first-2 sub-block SubBLKa2 may be isolated (for example, a bit line cut) from an upper cell region to pass through the bit line and connected to the first odd page buffer ODD PB1 through a bypass metal. A bit line corresponding to the second-2 sub-block SubBLKb2 may be connected to a second odd page buffer ODD PB2 through a through-via between the first cell region CELL1 and the second cell region CELL2.

A memory device according to various embodiments may include a first semiconductor layer including a first cell region and a second cell region over the first cell region, and a second semiconductor layer arranged under the first semiconductor layer in a vertical direction and including a page buffer circuit which includes a first page buffer set associated with odd data and a second page buffer set associated with even data, the first cell region may include a plurality of first memory cells, a first odd bit line transmitting odd data of the plurality of first memory cells, and a first even bit line transmitting even data of the plurality of first memory cells, the second cell region may include a plurality of second memory cells, a second odd bit line transmitting odd data of the plurality of second memory cells, and a second even bit line transmitting even data of the plurality of second memory cells, the first page buffer set may be connected to the first odd bit line from the first cell region and the second odd bit line from the second cell region, and the second page buffer set may be connected to the first even bit line from the first cell region and the second even bit line from the second cell region.

According to embodiments, the first page buffer set may include a first odd page buffer and a second odd page buffer.

According to embodiments, the first odd page buffer may be connected to the second odd bit line in the second cell region, and the second odd page buffer may be connected to the first odd bit line in the first cell region.

According to embodiments, the second page buffer set may include a first even page buffer and a second even page buffer.

According to embodiments, the first even page buffer may be connected to the first even bit line in the first cell region, and the second even page buffer may be connected to the second even bit line in the second cell region.

According to embodiments, the first odd page buffer may be connected to the first odd bit line in the first cell region, and the second odd page buffer may be connected to the second odd bit line in the second cell region.

According to embodiments, the first even page buffer may be connected to the second even bit line in the second cell region, and the second even page buffer may be connected to the first even bit line in the first cell region.

According to embodiments, the first cell region may include a first sub-block storing the odd data of the plurality of first memory cells and a second sub-block storing the even data of the plurality of first memory cells, the second cell region may include a third sub-block storing the odd data of the plurality of second memory cells and a fourth sub-block storing the even data of the plurality of second memory cells, and the first sub-block, the second sub-block, the third sub-block, and the fourth sub-block may each be divided based on a word line size.

A memory device according to various embodiments may include a first semiconductor layer including a first sub-block which includes a plurality of first memory cells, a first even bit line corresponding to even data of the plurality of first memory cells, and a first odd bit line corresponding to odd data of the plurality of first memory cells, and a second sub-block which includes a plurality of second memory cells, a second even bit line corresponding to even data of the plurality of second memory cells, and a second odd bit line corresponding to odd data of the plurality of second memory cells, and a second semiconductor layer arranged under the first semiconductor layer in a vertical direction and including a page buffer circuit which includes a first page buffer set associated with odd data and a second page buffer set associated with even data, wherein the first page buffer set may be connected to the first odd bit line from the first cell region and the second odd bit line from the second cell region, and the second page buffer set may be connected to the first even bit line from the first cell region and the second even bit line from the second cell region.

According to embodiments, the first page buffer set may include a first odd page buffer and a second odd page buffer.

According to embodiments, the first odd page buffer may be connected to the first odd bit line of the first sub-block, and the second odd page buffer may be connected to the second odd bit line of the second sub-block.

According to embodiments, the second page buffer set may include a first even page buffer and a second even page buffer.

According to embodiments, the first even page buffer may be connected to the first even bit line of the first sub-block, and the second even page buffer may be connected to the second even bit line of the second sub-block.

According to embodiments, the first even bit line may be adjacent to the second even bit line, and the first odd bit line may be adjacent to the second odd bit line.

According to embodiments, the first even bit line may be alternately repeated with respect to the second even bit line, and the first odd bit line may be alternately repeated with respect to the second odd bit line.

A memory device according to various embodiments may include a first semiconductor layer including a first sub-block which includes a plurality of first memory cells and first even bit lines corresponding to the plurality of first memory cells, a second sub-block which includes a plurality of second memory cells and first odd bit lines corresponding to the plurality of second memory cells, a third sub-block which includes a plurality of third memory cells and second even bit lines corresponding to the plurality of third memory cells, and a fourth sub-block which includes a plurality of fourth memory cells and second odd bit lines corresponding to the plurality of fourth memory cells, and a second semiconductor layer arranged under the first semiconductor layer in a vertical direction and including a page buffer circuit which includes a first page buffer set associated with odd data and a second page buffer set associated with even data, wherein the first page buffer set may be connected to the first odd bit line from the second sub-block and the second odd bit line from the fourth sub-block, and the second page buffer set may be connected to the first even bit line from the first sub-block and the second even bit line from the third sub-block.

According to embodiments, the first page buffer set may include a first odd page buffer and a second odd page buffer.

According to embodiments, the first odd page buffer may be connected to the first odd bit line of the second sub-block, and the second odd page buffer may be connected to the second odd bit line of the fourth sub-block.

According to embodiments, the second page buffer set may include a first even page buffer and a second even page buffer.

According to embodiments, the first even page buffer may be connected to the first even bit line of the first sub-block, and the second even page buffer may be connected to the second even bit line of the third sub-block.

According to embodiments, each of the first sub-block to the fourth sub-block may be divided based on a word line size.

A memory device according to various embodiments may include a first semiconductor layer including a first cell region and a second cell region over the first cell region, and a second semiconductor layer arranged under the first semiconductor layer in a vertical direction and including a page buffer circuit which includes a first page buffer set associated with odd data and a second page buffer set associated with even data, wherein the first cell region may include a first sub-block which includes a first even bit line for transmitting even data of first data, and a second sub-block which includes a second even bit line transmitting even data of second data and is arranged in a direction along word lines with respect to the first sub-block, the second cell region may include a third sub-block which includes a first odd bit line transmitting odd data of the first data and a fourth sub-block which includes a second odd bit line transmitting odd data of the second data and is arranged in a direction along word lines with respect to the third sub-block, the first page buffer set may be connected to the first odd bit line from the third sub-block and the second odd bit line from the fourth sub-block, and the second page buffer set may be connected to the first even bit line from the first sub-block and the second even bit line from the second sub-block.

According to embodiments, the first page buffer set may include a first odd page buffer and a second odd page buffer.

According to embodiments, the first odd page buffer may be connected to the first odd bit line of the second sub-block, and the second odd page buffer may be connected to the second odd bit line of the fourth sub-block.

According to embodiments, the second page buffer set may include a first even page buffer and a second even page buffer.

According to embodiments, the first even page buffer may be connected to the first even bit line of the first sub-block, and the second even page buffer may be connected to the second even bit line of the third sub-block.

FIG. 11 is a cross-sectional view of a memory device 500 having a B-VNAND structure, according to embodiments.

Referring to FIG. 11, the memory device 500 may have a chip-to-chip (C2C) structure. Here, the C2C structure may be obtained by manufacturing at least one upper chip including a cell region CELL and a lower chip including a peripheral circuit region PERI, and then connecting the at least one upper chip to the lower chip through bonding. For example, the bonding may mean an electrical or physical connection between a bonding metal pattern formed in an uppermost metal layer of the upper chip and a bonding metal pattern formed in an uppermost metal layer of the lower chip. For example, when each of the bonding metal patterns includes copper (Cu), the bonding may be Cu-Cu bonding. In another example, each of the bonding metal patterns may also include aluminum (Al) or tungsten (W).

The memory device 500 may include at least one upper chip including a cell region. For example, as illustrated in FIG. 11, the memory device 500 may include two upper chips. However, this is merely an example, and the number of upper chips is not limited thereto. When the memory device 500 includes two upper chips, the memory device 500 may be manufactured by manufacturing a first upper chip including a first cell region CELL1, a second upper chip including a second cell region CELL2, and a lower chip including a peripheral circuit region PERI, and then, connecting the first upper chip, the second upper chip, and the lower chip to each other through bonding. The first upper chip may be inverted and bonded to the lower chip, and the second upper chip may also be inverted and bonded to the first upper chip. In the following description, upper and lower portions of the first and second upper chips are defined based on the time before the first and second upper chips are inverted. That is, in FIG. 11, an upper portion of the lower chip refers to an upper portion defined relative to the +Z-axis direction, and an upper portion of each of the first and second upper chips refer to an upper portion defined relative to the -Z-axis direction. However, this is merely an example, and only one of the first and second upper chips may be inverted and connected thereto through bonding.

The peripheral circuit region PERI and the first and second cell regions CELL1 and CELL2 of the memory device 500 may each include an external pad bonding region PA, a word line bonding region WLBA, and a bit line bonding region BLBA.

The peripheral circuit region PERI may include a first substrate 210 and a plurality of circuit elements 220a, 220b, and 220c formed in the first substrate 210. An interlayer insulating layer 215 including one or more insulating layers may be provided on the plurality of circuit elements 220a, 220b, and 220c, and a plurality of metal wires connecting the plurality of circuit elements 220a, 220b, and 220c to each other may be provided within the interlayer insulating layer 215. For example, the plurality of metal wires may include first metal wires 230a, 230b, and 230c respectively connected to the plurality of circuit elements 220a, 220b, and 220c, and second metal wires 240a, 240b, and 240c formed on the first metal wires 230a, 230b, and 230c. The plurality of metal wires may each include at least one of various conductive materials. For example, the first metal wires 230a, 230b, and 230c may each include tungsten with relatively high electrical resistance, and the second metal wires 240a, 240b, and 240c may each include copper with relatively low electrical resistance.

Although only the first metal wires 230a, 230b, and 230c and the second metal wires 240a, 240b, and 240c are illustrated and described in the present specification, the disclosure is not limited thereto, and at least one metal wire may also be formed additionally on the second metal wires 240a, 240b, and 240c. In this case, the second metal wires 240a, 240b, and 240c may include aluminum. In addition, at least some of the additional metal wires formed on the second metal wires 240a, 240b, and 240c may each include copper or the like with lower electrical resistance than aluminum of each of the second metal wires 240a, 240b, and 240c.

The interlayer insulating layer 215 may be on the first substrate 210 and include an insulating material, such as silicon oxide, silicon nitride, or the like.

The first cell region CELL1 and the second cell region CELL2 may each include at least one memory block. The first cell region CELL1 may include a second substrate 310 and a common source line 320. A plurality of word lines 331 to 338 (or 330) may be stacked on the second substrate 310 in a direction (the Z-axis direction) that is perpendicular to an upper surface of the second substrate 310. String select lines and a ground select line may be arranged above and below the plurality of word lines 330, and the plurality of word lines 330 may be arranged between the string select lines and the ground select line. Similarly, the second cell region CELL2 may include a third substrate 410 and a common source line 420, and a plurality of word lines 431 to 438 (or 430) may be stacked on the third substrate 410 in a direction (the Z-axis direction) that is perpendicular to an upper surface of the third substrate 410. The second substrate 310 and the third substrate 410 may each include one of various materials, and may each be, for example, a silicon substrate, a silicon-germanium substrate, a germanium substrate, or a substrate including a singlecrystal epitaxial layer grown on a monocrystalline silicon substrate. A plurality of channel structures CH may be formed in each of the first cell region CELL1 and the second cell region CELL2.

In embodiments, as illustrated in A1 of FIG. 11, the channel structure CH may be provided in the bit line bonding region BLBA and may extend in a direction that is perpendicular to an upper surface of the second substrate 310 and pass through the word lines 330, the string select lines, and the ground select line. The channel structure CH may include a data storage layer, a channel layer, and a buried insulating layer. The channel layer may be electrically connected to a first metal wire 350c and a second metal wire 360c in the bit line bonding region BLBA. For example, the second metal wire 360c may be a bit line and be connected to the channel structure CH through the first metal wire 350c. The bit line may extend in a first direction (the X-axis direction) parallel to the upper surface of the second substrate 310.

In embodiments, as illustrated in A2 of FIG. 11, the channel structure CH may also include a lower channel LCH and an upper channel UCH connected to each other. For example, the channel structure CH may be formed through a process for the lower channel LCH and a process for the upper channel UCH. The lower channel LCH may extend in a direction that is perpendicular to an upper surface of the second substrate 310 and may pass through the common source line 320 and lower word lines 331 and 332. The lower channel LCH may include a data storage layer, a channel layer, a buried insulating layer, and so on and be connected to the upper channel UCH. The upper channel UCH may pass through upper word lines 333 to 338. The upper channel UCH may include a data storage layer, a channel layer, a buried insulating layer, and so on, and a channel layer of the upper channel UCH may be electrically connected to the first metal wire 350c and the second metal wire 360c. As a channel length increases, it may be more difficult to form a channel having a constant width due to a process reason. The memory device 500 according to embodiments may include a channel with improved width uniformity through the lower channel LCH and the upper channel UCH formed through a sequential process.

When the channel structure CH includes the lower channel LCH and the upper channel UCH as illustrated in A2 of FIG. 11, word lines located near a boundary between the lower channel LCH and the upper channel UCH may be dummy word lines. For example, the word lines 332 and 333, which form the boundary between the lower channel LCH and the upper channel UCH, may be dummy word lines. In this case, data may not be stored in memory cells connected to the dummy word lines. Alternatively, the number of pages corresponding to memory cells connected to the dummy word lines may be less than the number of pages corresponding to memory cells connected to regular word lines. Levels of voltages applied to the dummy word lines may differ from levels of voltages applied to the regular word lines, and accordingly, an impact of uneven channel widths between the lower channel LCH and the upper channel UCH on an operation of the memory device may be reduced.

In addition, in A2 of FIG. 11, the number of lower word lines 331 and 332 through which the lower channel LCH passes is less than the number of upper word lines 333 to 338 through which the upper channel UCH passes. However, this is an example, and the disclosure is not limited thereto. In another example, the number of lower word lines passing through the lower channel LCH may be equal to or greater than the number of upper word lines passing through the upper channel UCH. Also, a structure and connection relationship of the channel structure CH arranged in the first cell region CELL1 described above may be equally applied to the channel structure CH arranged in the second cell region CELL2.

In the bit line bonding region BLBA, a first through-electrode THV1 may be provided in the first cell region CELL1, and a second through-electrode THV2 may be provided in the second cell region CELL2. As illustrated in FIG. 11, the first through-electrode THV1 may pass through the common source line 320 and the plurality of word lines 330. However, this is merely an example, and the first through-electrode THV1 may further pass through the second substrate 310. The first through-electrode THV1 may include a conductive material. Alternatively, the first through-electrode THV1 may include a conductive material surrounded by an insulating material. The second through-electrode THV2 may also be provided with the same shape and structure as the first through-electrode THV1.

In embodiments, the first through-electrode THV1 may be electrically connected to the second through-electrode THV2 through a first through-metal pattern 372d and a second through-metal pattern 472d. The first through-metal pattern 372d may be formed in a lower portion of a first upper chip including the first cell region CELL1, and the second through-metal pattern 472d may be formed in an upper portion of a second upper chip including the second cell region CELL2. The first through- electrode THV1 may be electrically connected to the first metal wire 350c and the second metal wire 360c. A lower via 371d may be between the first through- electrode THV1 and the first through- metal pattern 372d, and an upper via 471d may be between the second through- electrode THV2 and the second through-metal pattern 472d. The first through-metal pattern 372d may be connected to the second through-metal pattern 472d through bonding.

Also, in the bit line bonding region BLBA, an upper metal pattern 252 may be on an uppermost metal layer of the peripheral circuit region PERI, and an upper metal pattern 392 having the same shape as the upper metal pattern 252 may be on an uppermost metal layer of the first cell region CELL1. The upper metal pattern 392 of the first cell region CELL1 may be electrically connected to the upper metal pattern 252 of the peripheral circuit region PERI through bonding. In the bit line bonding region BLBA, the bit line may be electrically connected to a page buffer included in the peripheral circuit region PERI. For example, some of circuit elements 220c in the peripheral circuit region PERI may provide page buffers, and the bit line may be electrically connected to the circuit elements 220c providing the page buffers through an upper bonding metal 370c of the first cell region CELL1 and an upper bonding metal 270c of the peripheral circuit region PERI.

Also, referring to FIG. 11, in the word line bonding region WLBA, the plurality of word lines 330 in the first cell region CELL1 may extend in a first direction (the X-axis direction) parallel to an upper surface of the second substrate 310 and be connected to a plurality of cell contact plugs 341 to 347 (or 340). A first metal wire 350b and a second metal wire 360b may be sequentially connected to upper portions of the plurality of cell contact plugs 340 respectively connected to the plurality of word lines 330. In the word line bonding region WLBA, the plurality of cell contact plugs 340 may be connected to the peripheral circuit region PERI through an upper bonding metal 370b of the first cell region CELL1 and an upper bonding metal 270b of the peripheral circuit region PERI.

The cell contact plugs 340 may be electrically connected to a row decoder included in the peripheral circuit region PERI. For example, some of the circuit elements 220b in the peripheral circuit region PERI may provide row decoders, and the plurality of cell contact plugs 340 may be connected respectively and electrically to the circuit elements 220b providing the row decoders through the upper bonding metal 370b in the first cell region CELL1 and the upper bonding metal 270b in the peripheral circuit region PERI. In embodiments, operation voltages of the circuit elements 220b providing the row decoders may be different from operation voltages of the circuit elements 220c providing the page buffers. For example, the operation voltages of the circuit elements 220c providing the page buffers may be higher than the operation voltages of the circuit elements 220b providing the row decoders.

Similarly, in the word line bonding region WLBA, word lines 430 in the second cell region CELL2 may extend in a first direction (the X-axis direction) parallel to an upper surface of the third substrate 410 and be connected to a plurality of cell contact plugs 441 to 447 (or 440). The plurality of cell contact plugs 440 may be connected to the peripheral circuit region PERI through an upper metal pattern of the second cell region CELL2, a lower metal pattern and upper metal pattern of the first cell region CELL1, and a cell contact plug 348.

In the word line bonding region WLBA, the upper bonding metal 370b may be in the first cell region CELL1, and the upper bonding metal 270b may be in the peripheral circuit region PERI. The upper bonding metal 370b in the first cell region CELL1 may be electrically connected to the upper bonding metal 270b of the peripheral circuit region PERI through bonding. The upper bonding metal 370b and the upper bonding metal 270b may each include aluminum, copper, tungsten, or so on.

In the external pad bonding region PA, a lower metal pattern 371e may be in a lower portion of the first cell region CELL1, and an upper metal pattern 472a may be in an upper portion of the second cell region CELL2. In the external pad bonding region PA, the lower metal pattern 371e of the first cell region CELL1 may be connected to the upper metal pattern 472a of the second cell region CELL2 through bonding. Similarly, an upper metal pattern 372a may be in an upper portion of the first cell region CELL1, and an upper metal pattern 272a may be in an upper portion of the peripheral circuit region PERI. The upper metal pattern 372a of the first cell region CELL1 and the upper metal pattern 272a of the peripheral circuit region PERI may be connected by bonding.

Common source line contact plugs 380 and 480 may be arranged in the external pad bonding region PA. The common source line contact plugs 380 and 480 may each include a conductive material, such as metal, a metal compound, or doped polysilicon. The common source line contact plug 380 of the first cell region CELL1 may be electrically connected to the common source line 320, and the common source line contact plug 480 of the second cell region CELL2 may be electrically connected to the common source line 420. A first metal wire 350a and a second metal wire 360a may be sequentially stacked on the common source line contact plug 380 of the first cell region CELL1, and a first metal wire 450a and a second metal wire 460a may be sequentially stacked on the common source line contact plug 480 of the second cell region CELL2.

Input/output pads 205, 405, and 406 may be arranged in the external pad bonding region PA. Referring to FIG. 11, a lower insulating layer 201 may cover a lower surface of the first substrate 210, and a first input/output pad 205 may be on the lower insulating layer 201. The first input/output pad 205 may be connected to at least one of a plurality of circuit elements 220a arranged in the peripheral circuit region PERI through the first input/output contact plug 203 and may be isolated from the first substrate 210 by the lower insulating layer 201. Also, a side insulating layer may be arranged between the first input/output contact plug 203 and the first substrate 210 and may electrically isolate the first input/output contact plug 203 from the first substrate 210.

An upper insulating layer 401 may be on an upper surface of the third substrate 410 to cover the upper surface of the third substrate 410. A second input/output pad 405 and/or a third input/output pad 406 may be over the upper insulating layer 401. The second input/output pad 405 may be connected to at least one of the plurality of circuit elements 220a arranged in the peripheral circuit region PERI through second input/output contact plugs 403 and 303, and the third input/output pad 406 may be connected to at least one of the plurality of circuit elements 220a arranged in the peripheral circuit region PERI through third input/output contact plugs 404 and 304.

In embodiments, the third substrate 410 may not be arranged in a region where input/output contact plugs are arranged. For example, as illustrated in B of FIG. 11, the third input/output contact plug 404 may be isolated from the third substrate 410 in a direction parallel to an upper surface of the third substrate 410 and be connected to the third input/output pad 406 by passing through an interlayer insulating layer 415 of the second cell region CELL2. In this case, the third input/output contact plug 404 may be formed through various processes.

For example, as illustrated in B1 of FIG. 11, the third input/output contact plug 404 may extend in a third direction (the Z-axis direction) and have a diameter that increases toward the upper insulating layer 401. That is, while a diameter of the channel structure CH described in A1 of FIG. 11 decreases toward the upper insulating layer 401, a diameter of the third input/output contact plug 404 may increase toward the upper insulating layer 401. For example, the third input/output contact plug 404 may be formed after the second cell region CELL2 is bonded to the first cell region CELL1.

Also, as illustrated in B2 of FIG. 11, the third input/output contact plug 404 may extend in a third direction (the Z-axis direction) and have a diameter that decreases toward the upper insulating layer 401. That is, the diameter of the third input/output contact plug 404 may decrease toward the upper insulating layer 401, similarly to the channel structure CH. For example, the third input/output contact plug 404 may be formed together with the cell contact plugs 440 before the second cell region CELL2 is bonded to the first cell region CELL1.

In embodiments, the second input/output contact plug 403 may be arranged to overlap the third substrate 410. For example, as illustrated in C of FIG. 11, the second input/output contact plug 403 may pass through the interlayer insulating layer 415 of the second cell region CELL2 in the third direction (the Z-axis direction), and may be electrically connected to the second input/output pad 405 through the third substrate 410. In this case, a connection structure between the second input/output contact plug 403 and the second input/output pad 405 may be implemented in various ways.

For example, as illustrated in C1 of FIG. 11, an opening 408 is formed to penetrate the third substrate 410, and the second input/output contact plug 403 may be directly connected to the second input/output pad 405 through the opening 408 formed in the third substrate 410. In this case, as illustrated in C1, a diameter of the second input/output contact plug 403 may increase toward the second input/output pad 405. However, this is merely an example, and the diameter of the second input/output contact plug 403 may also decrease toward the second input/output pad 405.

For example, as illustrated in C2 of FIG. 11, the opening 408 may be formed to penetrate the third substrate 410, and a contact 407 may be formed inside the opening 408. One end of the contact 407 may be connected to the second input/output pad 405, and the other end thereof may be connected to the second input/output contact plug 403. Accordingly, the second input/output contact plug 403 may be electrically connected to the second input/output pad 405 through the contact 407 in the opening 408. In this case, as illustrated in C2, a diameter of the contact 407 may increase toward the second input/output pad 405, and a diameter of the second input/output contact plug 403 may decrease toward the second input/output pad 405. For example, the second input/output contact plug 403 may be formed together with the cell contact plugs 440 before the second cell region CELL2 is bonded to the first cell region CELL1, and the contact 407 may be formed after the second cell region CELL2 is bonded to the first cell region CELL1.

Also, as illustrated in C3 of FIG. 11, a stopper 409 may also be provided on an upper surface of the opening 408 of the third substrate 410 compared to C2. The stopper 409 may be a metal wire formed on the same layer as the common source line 420. However, this is merely an example, and the stopper 409 may also be a metal wire formed on the same layer as at least one of the word lines 430. The second input/output contact plug 403 may be electrically connected to the second input/output pad 405 through the contact 407 and the stopper 409.

In addition, similarly to the second and third input/output contact plugs 403 and 404 of the second cell region CELL2, the second and third input/output contact plugs 303 and 304 of the first cell region CELL1 may each have a diameter that decreases toward the lower metal pattern 371e, or increases toward the lower metal pattern 371e.

In addition, according to embodiments, a slit 411 may be formed in the third substrate 410. For example, the slit 411 may be formed at a certain position in the external pad bonding region PA. For example, as illustrated in D of FIG. 11, the slit 411 may be between the second input/output pad 405 and the cell contact plugs 440 in a plan view. However, this is merely an example, and the slit 411 may also be formed such that the second input/output pad 405 is between the slit 411 and the cell contact plugs 440 when viewed in a plan view.

For example, as illustrated in D1 of FIG. 11, the slit 411 may be formed to penetrate the third substrate 410. The slit 411 may be used to prevent the third substrate 410 from being finely cracked, for example, when forming the opening 408. However, this is merely an example, and the slit 411 may also be formed to have a depth of about 60 % to about 70 % of a thickness of the third substrate 410.

Also, as illustrated in D2 of FIG. 11, a conductive material 412 may also be formed inside the slit 411. For example, the conductive material 412 may be used to discharge a leakage current, which is generated during operations of circuit elements in the external pad bonding region PA, to the outside. In this case, the conductive material 412 may also be connected to an external ground line.

Also, as illustrated in D3 of FIG. 11, an insulating material 413 may also be inside the slit 411. For example, the insulating material 413 may electrically isolate the second input/output pad 405 and the second input/output contact plug 403 in the external pad bonding region PA from the word line bonding region WLBA. By forming the insulating material 413 inside the slit 411, a voltage provided through the second input/output pad 405 may be prevented from affecting a metal layer on the third substrate 410 in the word line bonding region WLBA.

In addition, depending on embodiments, the first to third input/output pads 205, 405, and 406 may be selectively formed. For example, the memory device 500 may include only the first input/output pad 205 on the first substrate 210, or only the second input/output pad 405 on the third substrate 410, or only the third input/output pad 406 on the upper insulating layer 401.

In addition, depending on embodiments, at least one of the second substrate 310 of the first cell region CELL1 and the third substrate 410 of the second cell region CELL2 may be used as a sacrificial substrate and may be completely or partially removed before or after a bonding process. An additional layer may be stacked after the substrate is removed. For example, the second substrate 310 of the first cell region CELL1 may be removed before or after the peripheral circuit region PERI is bonded to the first cell region CELL1, and an insulating layer covering an upper surface of the common source line 320 or a conductive layer for connection may be formed. Similarly, the third substrate 410 of the second cell region CELL2 may be removed before or after the first cell region CELL1 is bonded to the second cell region CELL2, and the upper insulating layer 401 covering an upper surface of the common source line 420 or a conductive layer for connection may be formed.

According to embodiments, upper bonding metals 270c of the peripheral circuit region PERI may be in an upper portion of the peripheral circuit region PERI in a page buffer circuit region and may be arranged in a matrix form in the first direction X and the second direction Y. The page buffer circuit region may correspond to the bit line bonding region BLBA. For example, the upper bonding metals 270c may be grouped into a plurality of bonding pad groups, each of which may include upper bonding metals arranged in a row along the first direction X. According to embodiments, the peripheral circuit region PERI may include a plurality of through-wires extending in the first direction X. For example, each through-wire may be arranged between adjacent bonding pad groups.

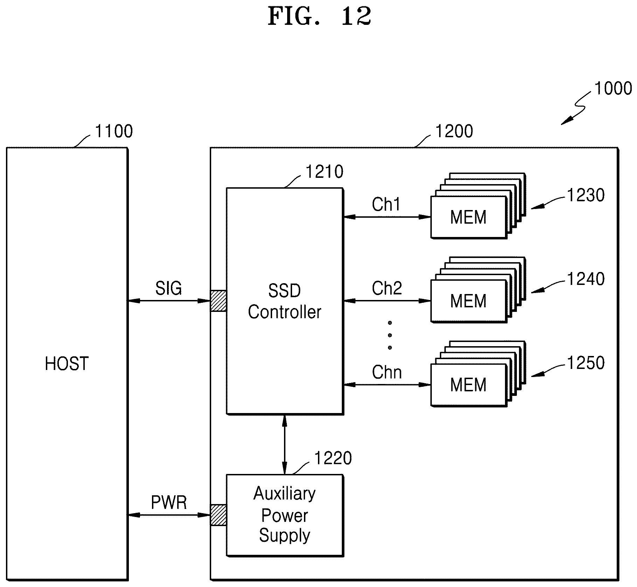

FIG. 12 is a block diagram illustrating an example in which a memory device is applied to a solid state disk (SSD) system 1000, according to embodiments.

Referring to FIG. 12, the SSD system 1000 may include a host 1100 and an SSD 1200. The SSD 1200 may exchange signals SIG with the host 1100 through a signal connector and receive power PWR through a power connector. The SSD 1200 may include an SSD controller 1210, an auxiliary power supply 1220, and memory devices 1230, 1240, and 1250. The memory devices 1230, 1240, and 1250 may be vertically stacked NAND flash memory devices. In this case, the SSD 1200 may be implemented by using the embodiments described above with reference to FIGS. 1 to 11.

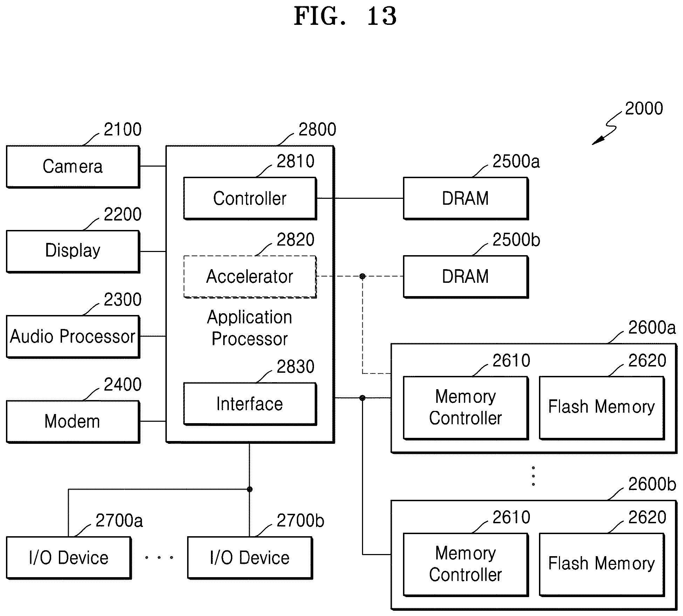

FIG. 13 is a block diagram of a system 2000 illustrating an electronic device including a memory device, according to embodiments.

Referring to FIG. 13, the system 2000 may include a camera 2100, a display 2200, an audio processor 2300, a modem 2400, DRAMs 2500a and 2500b, flash memories 2600a and 2600b, I/O devices 2700a and 2700b, and an application processor (AP) 2800 (hereinafter referred to as an "AP"). The system 2000 may be implemented by a laptop computer, a mobile phone, a smart phone, a tablet personal computer (PC), a wearable device, a healthcare device, or an Internet of things (IoT) device. Also, the system 2000 may also be implemented by a server or a personal computer.

The camera 2100 may capture still or moving images under the control by a user, and may store the captured image/video or transmit data to the display 2200. The audio processor 2300 may process audio data included in the flash memories 2600a and 2600b or network content. The modem 2400 may modulate signals for wired/wireless data transmission and reception and transmit the modulated signals, and a receiver thereof may perform demodulation to restore the received signals to original signals. The I/O devices 2700a and 2700b may include devices that provide digital input and/or output functions, such as a Universal Serial Bus (USB), a storage, a digital camera, a secure digital (SD) card, a digital versatile disc (DVD), a network adapter, and a touch screen.

The AP 2800 may control all operations of the system 2000. The AP 2800 may include a controller 2810, an accelerator or accelerator chip 2820, and an interface 2830. The AP 2800 may control the display 2200 such that a part of the content stored in the flash memories 2600a and 2600b is displayed on the display 2200. When a user input is received through the I/O devices 2700a and 2700b, the AP 2800 may perform a control operation corresponding to the user input. The AP 2800 may include an accelerator 2820 that is a dedicated circuit for artificial intelligence (AI) data operations, or may include the accelerator chip 2820 separately from the AP 2800. The DRAM 2500b may be further mounted on the accelerator or the accelerator chip 2820. The accelerator 2820 is a functional block that specializes in performing a certain function of the AP 2800, and may include a graphics processing unit (GPU) which is a functional block that specializes in processing graphic data, a neural processing unit (NPU) which is a block that specializes in performing AI calculation and inference, and a data processing unit (DPU) which is a block that specializes in data transmission.

The system 2000 may include a plurality of DRAMs 2500a and 2500b. The AP 2800 may control the plurality of DRAMs 2500a and 2500b through commands and mode register (MRS) setting that conform to the joint electron device engineering council (JEDEC) standard, or may perform communication by setting a DRAM interface protocol to utilize unique vendor features, such as a low voltage, a high speed, and reliability, and cyclic redundancy check (CRC)/error correction code (ECC) functions. For example, the AP 2800 may communicate with the DRAM 2500a through an interface that conforms to the JEDEC standard, such as LPDDR4 or LPDDR5, and the accelerator or accelerator chip 2820 may perform communication by setting a new DRAM interface protocol to control the DRAM 2500b for an accelerator, which has a higher bandwidth than the DRAM 2500a.

Although FIG. 13 illustrates only the DRAMs 2500a and 2500b, the disclosure is not limited thereto, and any memory, such as phase-change random access memory (PRAM), static RAM (SRAM), magnetic RAM (MRAM), resistive RAM (RRAM), ferroelectric RAM (FRAM), or hybrid RAM, may be used for the DRAM as long as a bandwidth, a response speed, and voltage conditions of the AP 2800 or the accelerator chip 2820 are satisfied. The DRAMs 2500a and 2500b may have relatively less latency and bandwidth than the I/O devices 2700a and 2700b or the flash memories 2600a and 2600b. The DRAMs 2500a and 2500b may be initialized when the system 2000 is powered on, and may be used as temporary storages for an operating system and application data when the operating system and application data are loaded, or may be used as execution spaces for various software codes.

Four basic arithmetic operations, such as addition, subtraction, multiplication, and division, vector operations, address operations, or fast Fourier transform (FFT) operations may be performed by the DRAMs 2500a and 2500b. Also, functions for performing inference may be performed by the DRAMs 2500a and 2500b. Here, the inference may be performed by a deep learning algorithm using an artificial neural network. The deep learning algorithm may include a training operation of training a model using various types of data, and an inference operation of recognizing data by using the trained model. According to embodiments, an image captured by a user through the camera 2100 may be signal-processed and stored in the DRAM 2500b, and the accelerator or accelerator chip 2820 may perform AI data operations that recognize data using the data stored in the DRAM 2500b and a function used for inference.

The system 2000 may include a plurality of storage devices with larger capacities than capacities of the DRAM 2500a or 2500b, or the flash memories 2600a and 2600b. The accelerator or accelerator chip 2820 may perform a training operation and an AI data operation using the flash memories 2600a and 2600b. In embodiments, the flash memories 2600a and 2600b may each include a memory controller 2610 and a flash memory device 2620, and may more efficiently perform a training operation and an inference AI data operation performed by the AP 2800 and/or the accelerator chip 2820 using an arithmetic unit included in the memory controller 2610. The flash memories 2600a and 2600b may store photos taken by the camera 2100 or data received through a data network. For example, the flash memories 2600a and 2600b may store augmented reality (AR)/virtual reality (VR), high definition (HD), or ultra high definition (UHD) content.

According to embodiments, power may be saved by precharging only a word line size of a certain unit, rather than precharging the entire word line size.

Effects achieved by the embodiments are not limited to the effects described above, and other effects not described may be clearly derived and understood by those skilled in the art to which the embodiments pertain, based on the above description. That is, unintended effects resulting from implementation of the embodiments may also be derived by those skilled in the art from the embodiments.

As described above, embodiments are disclosed in the drawings and specification. While specific terminology is used to describe the embodiments herein, such terminology is used solely to illustrate the technical idea of the disclosure and is not intended to limit the meaning or the scope of the disclosure as set forth in the claims. Therefore, those skilled in the art will understand that various modifications and equivalent embodiments may be derived therefrom. Accordingly, the true technical protection scope of the disclosure should be defined by the technical idea of the appended claims.

While the disclosure has been particularly shown and described with reference to embodiments thereof, it will be understood that various changes in form and details may be made therein without departing from the scope of the following claims.

## Claims

1. A memory device (10) comprising:
a first semiconductor layer including a first cell region (CELL1) and a second cell region (CELL2) over the first cell region (CELL1); and
a second semiconductor layer arranged under the first semiconductor layer in a substantially vertical direction (Z) and including a page buffer circuit (17) which includes a first page buffer set (17_1) associated with odd data and a second page buffer set (17_2) associated with even data,
wherein:
the first cell region (CELL1) includes a plurality of first memory cells, a first odd bit line (BL2_1F) transmitting odd data (2nd ODD) of the plurality of first memory cells, and a first even bit line (BL1_1F) transmitting even data (2nd EVEN) of the plurality of first memory cells,
the second cell region (CELL2) includes a plurality of second memory cells, a second odd bit line (BL1_2F) transmitting odd data (1st ODD) of the plurality of second memory cells, and a second even bit line (BL2_2F) transmitting even data (1st EVEN) of the plurality of second memory cells,
the first page buffer set (17_1) is connected to the first odd bit line (BL2 _1F) of the first cell region (CELL1) and the second odd bit line (BL1_2F) of the second cell region (CELL2), and
the second page buffer set (17_2) is connected to the first even bit line (BL1_1F) of the first cell region (CELL1) and the second even bit line (BL2_2F) of the second cell region (CELL2).

2. The memory device (10) of claim 1, wherein the first page buffer set (17_1) includes a first odd page buffer (ODD PB1) and a second odd page buffer (ODD PB2).

3. The memory device (10) of claim 2, wherein:
the first odd page buffer (ODD PB1) is connected to the second odd bit line (BL1_2F) in the second cell region (CELL2), and
the second odd page buffer (ODD PB2) is connected to the first odd bit line (BL2_1F) in the first cell region (CELL1).

4. The memory device (10) of claim 2 or claim 3, wherein the second page buffer set (17_2) includes a first even page buffer (EVEN PB1) and a second even page buffer (EVEN PB2).

5. The memory device (10) of claim 4, wherein:
the first even page buffer (EVEN PB1) is connected to the first even bit line (BL1_1F) in the first cell region (CELL1), and
the second even page buffer (EVEN PB2) is connected to the second even bit line (BL1_2F) in the second cell region (CELL2).

6. The memory device (10) of claim 2, wherein:
the first odd page buffer (ODD PB 1) is connected to the first odd bit line (BL2_1F) in the first cell region (CELL1), and
the second odd page buffer (ODD PB2) is connected to the second odd bit line (BL1_2F) in the second cell region (CELL2).

7. The memory device (10) of claim 4, wherein:
the first even page buffer (EVEN PB 1) is connected to the second even bit line (BL2_2F) in the second cell region (CELL2), and
the second even page buffer (EVEN PB2) is connected to the first even bit line (BL1_1F) in the first cell region (CELL1).

8. A memory device (10) comprising:
a first semiconductor layer including a first sub-block (SubBLKa) which includes a plurality of first memory cells, a first even bit line (BL1) corresponding to even data of the plurality of first memory cells, and a first odd bit line (BL2) corresponding to odd data of the plurality of first memory cells, and a second sub-block (SubBLKb) which includes a plurality of second memory cells, a second even bit line (BL3) corresponding to even data of the plurality of second memory cells, and a second odd bit line (BL4) corresponding to odd data of the plurality of second memory cells; and
a second semiconductor layer arranged under the first semiconductor layer in a substantially vertical direction (Z) and including a page buffer circuit (17) which includes a first page buffer set (17_1) associated with odd data and a second page buffer set (17_2) associated with even data,
wherein the first page buffer set (17_1) is connected to the first odd bit line (BL2) of the first sub-block (SubBLKa) and the second odd bit line (BL4) of the second sub-block (SubBLKb), and
the second page buffer set (17_2) is connected to the first even bit line (BL1) of the first sub-block (SubBLKa) and the second even bit line (BL3) of the second sub-block (SubBLKb).

9. The memory device (10) of claim 8, wherein the first page buffer set includes a first odd page buffer (ODD PB1) and a second odd page buffer (ODD PB2).

10. The memory device (10) of claim 9, wherein the first odd page buffer (ODD PB1) is connected to the first odd bit line (BL2) of the first sub-block (SubBLKa).

11. The memory device (10) of claim 9 or claim 10, wherein the second odd page buffer (ODD PB2) is connected to the second odd bit line (BL4) of the second sub-block (SubBLKb).

12. The memory device (10) of any of claims 9-11, wherein the second page buffer set (17_2) includes a first even page buffer (EVEN PB1) and a second even page buffer (EVEN PB2).

13. The memory device (10) of claim 12, wherein:
the first even page buffer (EVEN PB1) is connected to the first even bit line (BL1) of the first sub-block (SubBLKa), and
the second even page buffer (EVEN PB2) is connected to the second even bit line (BL3) of the second sub-block (SubBLKb).

14. The memory device (10) of any of claims 8-13, wherein:
the first even bit line (BL1) is adjacent to the second even bit line (BL3), and
the first odd bit line (BL2) is adjacent to the second odd bit line (BL4).

15. The memory device (10) of any of claims 8-13, wherein:
the first even bit line (BL1) is alternately repeated with respect to the second even bit line (BL3), and
the first odd bit line (BL2) is alternately repeated with respect to the second odd bit line (BL4).
